(19) Europäisches Patentamt
European Patent Office
Office européen des brevets

(11) Veröffentlichungsnummer : **0 207 893**
**B1**

(12) # EUROPÄISCHE PATENTSCHRIFT

(45) Veröffentlichungstag der Patentschrift : **03.01.90**

(51) Int. Cl.$^5$ : **G 03 F 7/16**, G 03 F 7/20

(21) Anmeldenummer : **86810270.8**

(22) Anmeldetag : **13.06.86**

(54) **Verfahren zur Bilderzeugung.**

(30) Priorität : **19.06.85 GB 8515475**

(43) Veröffentlichungstag der Anmeldung : **07.01.87 Patentblatt 87/02**

(45) Bekanntmachung des Hinweises auf die Patenterteilung : **03.01.90 Patentblatt 90/01**

(84) Benannte Vertragsstaaten : **BE CH DE FR GB IT LI NL SE**

(56) Entgegenhaltungen :
**EP-A- 0 086 474**
**DD-A- 158 281**
**GB-A- 2 127 324**
**US-A- 3 784 378**
**US-A- 3 859 091**
**US-A- 4 291 118**
**US-A- 4 413 052**
**US-A- 4 416 975**
**US-A- 4 426 431**
**PATENT ABSTRACTS OF JAPAN, Band 5, Nr. 19 (E-44)[691], 4. Februar 1981; & JP-A-55 148 423 (CHO LSI GIJUTSU KENKYU KUMIAI) 19-11-1980**
**PATENT ABSTRACTS OF JAPAN, Band 6, Nr. 25 (E-94)[903], 13. Februar 1982; & JP-A-56 144 539 (HITACHI SEISAKUSHO K.K.) 10-11-1981**

(73) Patentinhaber : **CIBA-GEIGY AG**
**Klybeckstrasse 141**
**CH-4002 Basel (CH)**

(72) Erfinder : **Goodin, Jonathan William, Dr.**
**20C Buchenbusch 5.O.G.**
**D-6078 Neu-Isenburg (DE)**
Erfinder : **Irving, Edward, Dr.**
**41, Swaffham Road**
**Burwell Cambridge CB5 0AN (GB)**
Erfinder : **Banks, Christopher Paul**
**105 Ross Close**
**Saffron Walden Essex CB11 4DU (GB)**

**EP 0 207 893 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein Verfahren zur Bilderzeugung aus flüssigen Ueberzügen auf Substraten durch aktinische Bestrahlung bei verschiedenen Wellenlängen.

Bilderzeugung durch Photopolymerisierung wird üblicherweise dadurch erreicht, dass man eine Unterlage mit einer Lösung einer photopolymerisierbaren Substanz in einem flüchtigen organischen Lösungsmittel beschichtet, das Lösungsmittel verdampfen lässt, wodurch ein Film der photopolymerisierbaren Substanz entsteht, den Film durch eine Vorlage aktinisch bestrahlt, wobei die bestrahlten Teile des Films photopolymerisiert und dadurch weniger löslich werden, während die von der Strahlung geschützten Teile im wesentlichen unverändert bleiben, und dann die nicht bestrahlten, nicht polymerisierten Teile des Films durch ein geeignetes Lösungsmittel, welches die bestrahlten photopolymerisierten Teile nicht löst, weglöst. Diese letzte Stufe wird üblicherweise « Entwicklung » genannt.

Es wäre wünschenswert, ein Verfahren zu haben, worin eine Schicht einer photopolymerisierbaren Substanz auf eine Unterlage appliziert wird und diese Schicht in eine im wesentlichen feste, nicht-klebrige Form gebracht wird, welche man durch eine Vorlage belichten kann, ohne dabei organische Lösungsmittel verwenden zu müssen. Dadurch wären nicht nur die mit der Verwendung von Lösungsmitteln verbundenen Probleme mit der Toxizität und Entflammbarkeit sowie die Kosten der Wiedergewinnung der Lösungsmittel vermieden, sondern auch die kontinuierliche Herstellung von beschichteten Unterlagen, welche durch Vorlagen belichtet werden können, wäre erleichtert.

Es wurde nun gefunden, dass dieses Ziel erreicht werden kann, wenn bestimmte flüssige Gemische zweier oder mehrerer Verbindungen, und/oder mindestens eine doppelfunktionelle Verbindung verwendet werden, welche durch aktinische Strahlung polymerisiert werden können, aber bei denen die zwei Verbindungen oder die zwei funktionellen Gruppen der doppelfunktionellen Verbindung bei verschiedenen Wellenlängen empfindlich sind. Die Verfestigung der Schicht wird durch Bestrahlung bei längerer Wellenlänge erreicht, wobei eine stabile, feste aber immer noch photoempfindliche Schicht entsteht. Da das andere strahlungsempfindliche Material oder die andere funktionelle Gruppe nur bei kürzerer Wellenlänge empfindlich ist, d. h. nur bei aktinischer Strahlung höherer Energie reagiert, hat eine längere Bestrahlung mit Strahlung längerer Wellenlänge, d. h. tieferer Energie, nur einen vernachlässigbaren Einfluss auf das verfestigte Material. Deshalb ist bei Bestrahlung mit längerer Wellenlänge keine genaue Kontrolle der Bestrahlungszeit nötig, und danach kann die Beschichtung längere Zeit in Abwesenheit von Strahlung kürzerer Wellenlänge gelagert werden. Wenn gewünscht, werden Teile des Stoffgemisches der Strahlung kürzerer Wellenlänge ausgesetzt, bei der das Stoffgemisch empfindlich ist. Dann werden die bestrahlten Bereiche weiter polymerisiert, so dass diese Bereiche von den jetzt nicht bestrahlten Bereichen unterschiedliche physikalische Eigenschaften aufweisen. Die Bereiche, welche nur einer Bestrahlung ausgesetzt waren, werden dann mit einem geeigneten Lösungsmittel oder auf andere Art entfernt.

Die U.S. Patentschrift 4 291 118 beschreibt ein Verfahren zur Reliefbilderzeugung aus einem flüssigen photopolymerisierbaren Material, indem die Schicht durch chemische Härtung verfestigt wird, wobei die Härtung meistens durch aktinische Bestrahlung eingeleitet wird, dann die verfestigte Schicht noch einmal durch eine Vorlage bestrahlt wird, so dass Teile der Schicht chemisch verschieden werden, und schliesslich die Teile, die nicht nachbestrahlt sind, mit einem Lösungsmittel entfernt werden. Die Möglichkeit einer Verwendung von Strahlung zwei verschiedener Wellenlängen für die zwei Bestrahlungen wird nicht erwähnt. Im Ausführungsbeispiel erfolgen beide Bestrahlungen mit der gleichen stationären Xenon-Puls-Lichtquelle. Die einzigen photopolymerisierbaren Stoffe, welche erwähnt sind, sind Gemische von Polyenen mit Polythiolen. Dieses Verfahren kann nicht auf einfache Weise erfolgreich durchgeführt werden. Während der ersten Bestrahlung muss sehr sorgsam vorgegangen werden, um die richtige Strahlungsmenge zu applizieren, weil bei zu kleiner Menge das flüssige Stoffgemisch nicht verfestigt wird, und bei zu grosser Menge dann mit der zweiten Bestrahlung kein gutes Bild erzeugt werden kann. Zudem, verläuft die Reaktion zwischen dem Polyen und dem Polythiol, welche durch die Bestrahlung initiiert wird, auch nachdem die Bestrahlung aufgehört hat weiter. Aus diesem Grund wird in der erwähnten Patentschrift empfohlen, die zweite Bestrahlung innerhalb von weniger als 30 Minuten, und vorzugsweise innerhalb von weniger als 10 Minuten nach der ersten Bestrahlung anzufangen, und es wird gesagt, dass in vielen Systemen mit einer Zeit zwischen den zwei Bestrahlungen von 30 Minuten oder länger keine zufriedenstellende Differenzierung des chemischen Zustandes in der verfestigten Masse mehr möglich ist. Diese Zeitbeschränkung bedeutet eine weitere Einschränkung für die industrielle Anwendbarkeit des Verfahrens.

Das wesentliche Prinzip des erfindungsgemässen Verfahrens ist die Tatsache, dass das härtbare Gemisch zwei verschiedene Reste, durch die die Polymerisation oder Härtung stattfindet, aufweist, wobei ein Rest direkt oder indirekt mit einer Bestrahlung aktiviert werden kann, die längerwellig ist als die längste Wellenlänge mit der der andere Rest aktiviert wird, so dass durch die Bestrahlung selektiv ein Rest reagiert, während der andere photohärtbar bleibt. Aus dem Stand der Technik war nicht bekannt, dass eine solche Behandlung feste Ueberzüge ergibt, welche bei zweiter Bestrahlung, sogar nach einer langen Zeit zwischen den zwei Bestrahlungen ein Bild liefern.

Zweistufige Bestrahlungsverfahren zur Bilderzeugung sind auch aus den U.S. Patentschriften

4 413 052 und 4 416 975 bekannt. In der ersten wird ein flüssiges Stoffgemisch enthaltend eine Verbindung mit einer (Meth)acryloylgruppe und einer Anthrylgruppe durch Bestrahlung verfestigt, und ein Bild wird durch eine zweite Bestrahlung durch ein Negativ erzeugt. Das zweite US Patent beschreibt ein ähnliches Verfahren mit der Ausnahme, dass die Anthrylgruppe durch eine 2,3-disubstituierte Maleinimidgruppe ersetzt ist. In keiner dieser Patentschriften wird die Möglichkeit der Verwendung von Bestrahlung verschiedener Wellenlänge erwähnt. Der Unterschied in der Wirkung der ersten und der zweiten Bestrahlung ist durch die Länge der Bestrahlung bestimmt, wobei die zweite Bestrahlung eine 15 bis 100 malige Lichtenergie der ersten benötigt. Deshalb besteht dabei die Gefahr, dass, falls die erste Bestrahlung länger als die für die Verfestigung benötigte Minimalzeit fortgesetzt wird, es zum Teil zur vollständigen Härtung kommt, und folglich kein Bild mehr erzeugt werden kann. Ein weiterer Nachteil der in diesen zwei Patenten beschriebenen Verfahren ist die Länge der zweiten Bestrahlung, welche gemäss den Beispielen bis zu 20 Minuten benötigt. Wenn für den zweiten photopolymerisierbaren Stoff ein reaktiveres System verwendet würde, wäre die Gefahr, dass die erste Bestrahlung bereits vollständige Härtung verursacht, noch grösser, und die Bilderzeugung wäre schwierig oder unmöglich. Deshalb ist bei diesen Verfahren eine lange zweite Bestrahlung unvermeidbar.

Die Verwendung von Gemischen photohärtbarer Stoffe ist schon in der U.S. Patentschrift 4 426 431 beschrieben, welche solche Gemische als verschleissfeste Ueberzüge beansprucht. Diese Patentschrift beschreibt Stoffgemische enthaltend.

1. eine polymerisierbare Epoxidverbindung, z. B. einen Polyglycidylether eines aliphatischen Polyols,
2. einen kationischen Polymerisationsinitiator für 1, z. B. ein aromatisches Oniumsalz,
3. eine polymerisierbare Acrylverbindung, z. B. Pentaerythritoltriacrylat,
4. ein halogenalkyliertes aromatisches Keton als Initiator freier Radikale für 3, z. B. ein halomethyliertes Benzophenon, und
5. ein polymerisierbares organofunktionelles Silan, z. B. ein Epoxysilan oder ein acryliertes Silan.

Diese Stoffgemische werden als Flüssigkeiten appliziert und durch eine einzige UV Bestrahlung gehärtet. Eine Bilderzeugung durch Verwendung dieser Stoffgemische ist nicht erwähnt.

Die Verwendung bifunktioneller härtbarer Systeme, deren beide Funktionen durch Strahlungsenergie aktiviert werden, ist in der U.S. Patentschrift 4 428 807 beschrieben. Es werden Stoffgemische offenbart, enthaltend einen zum Teil esterifizierten Epoxyester, hergestellt aus einem Epoxid und einer am Schluss der Kette ungesättigten Monocarbonsäure, mit einem bifunktionellen Härtersystem, welches bei Bestrahlung sowohl eine Polymerisierung durch freie Radikale als auch eine kationische Polymerisierung initiieren kann. Dieses Härtersystem ist ein Gemisch eines Initiators freier Radikale, z. B. eines Benzoin- oder Acyloinethers, mit einem aromatischen Oniumsalz, z. B. p-tert.Butylphenyliodoniumhexafluorphosphat. Diese Stoffgemische werden durch Bestrahlung aus einer einzigen Strahlenquelle gehärtet. Sie werden als Ueberzüge verwendet, welche eine gute Adhesion auf Metallen, z. B. auf Aluminium, aufweisen. Eine Möglichkeit zweistufiger Bestrahlung aus zwei verschiedenen Quellen wird nicht erwähnt.

Die DD Patentschrift 158 281, welche im Chemical Abstracts, 99, 96846y zusammengefasst ist, offenbart die Bilderzeugung unter Verwendung eines Stoffgemisches enthaltend eine ethylenisch ungesättigte Verbindung, einen Initiator für radikalische Polymerisierung dieser Verbindung, ein kationisch polymerisierbares Material und einen Coinitiator dafür. Ein beispielhaft belegtes Stoffgemisch enthielt Glycidylmethacrylat, einen Acrylsäure-Ethylacrylat-Styrol-Copolymer, Benzoinisopropylether und p-Methoxybenzoldiazoniumhexafluorphosphat. Diese Stoffgemische, welche eine verbesserte Lichtempfindlichkeit, eine hohe Vernetzungsgeschwindigkeit und verbesserte mechanische Eigenschaften aufweisen sollen, werden durch eine einmalige Bestrahlung gehärtet.

In den Patents Abstracts of Japan, Bd. 5, Nr. 19 (E44) (691) wird ein Positivresist beschrieben, indem ein Film eines vernetzbaren Polyacrylats durch gleichzeitige Einwirkung von Wärme und UV-Strahlen vernetzt wird, und das Produkt danach mit Elektronenstrahlen oder Röntgenstrahlen in einem vorbestimmten Muster solubilisiert wird.

Die U.S. Patentschrift 3 784 378 beschreibt ein weiteres Verfahren zur Erzeugung von Positivbildern, worin ein Gemisch eines photopolymerisierbaren oder eines photovernetzbaren Stoffes mit zwei Photoinitiatoren, welche bei verschiedenen Wellenlängen aktivierbar sind, in der ersten Stufe bildmässig bei einer Wellenlänge so lange belichtet wird bis die belichteten Stellen durch weitere Bestrahlung nicht mehr polymerisiert werden können, und danach die Gesamtfläche einer Strahlung einer anderen Wellenlänge ausgesetzt wird, wobei die in der ersten Stufe nicht belichteten Stellen gehärtet werden. Beide Belichtungsstufen werden in Gegenwart eines Polymerisationsinhibitors vorgenommen.

Die Bilderzeugung durch ein Verfahren, in welchem die Verfestigung zuerst bei einer Wellenlänge, und die Bilderzeugung bei einer zweiten, kürzeren (d. h. energiereicheren) Wellenlänge stattfindet, ist bis jetzt nicht beschrieben worden.

Die vorliegende Erfindung betrifft ein Verfahren zur Bilderzeugung in dem

(i) auf ein Substrat eine Schicht eines flüssigen Stoffgemisches appliziert wird, enthaltend

(A) einen durch freie Radikale polymerisierbaren Rest,

(B) einen strahlungsaktivierbaren Polymerisationsinitiator für (A),

(C) einen strahlungshärtbaren Rest, der verschieden von (A) ist, und gegebenenfalls

(D) einen strahlungsaktivierbaren Katalysator für die Härtung von (C),

(ii) das Stoffgemisch aktinischer Bestrahlung einer Wellenlänge, bei der der Initiator (B) aktiviert wird, aber der Rest (C) und/oder der Katalysator (D) nicht wesentlich aktiviert werden aussetzt, wodurch (A) polymerisiert und die flüssigen Schicht des Stoffgemisches verfestigt wird, aber immer noch härtbar bleibt,

(iii) die verfestigte Schicht in einem vorbestimmten Muster aktinischer Strahlung ausgesetzt wird, welche eine kürzere Wellenlänge als die Bestrahlung der Stufe (ii) hat und bei der der strahlungshärtbare Rest (C) und/oder der Katalysator (D) aktiviert werden, so dass in den bestrahlten Bereichen (C) im wesentlichen gehärtet wird, und (iv) die Bereiche der verfestigten Schicht, welche nicht im wesentlichen gehärtet sind, entfernt werden.

Der Ausdruck « in einem vorbestimmten Muster aktinischer Strahlung aussetzen » umfasst sowohl Bestrahlung durch ein bildtragendes Dia, welches undurchsichtige und durchsichtige Teile aufweist, als auch Bestrahlung mit einem Strahl, welcher in einem vorbestimmten Muster, z. B. von einem Computer, bewegt wird, so dass ein Bild erzeugt wird.

Die härtbaren flüssigen Stoffgemische, die erfindungsgemäss verwendet werden können, können ein Gemisch einer oder mehrerer Verbindungen, die bei einer bestimmten Wellenlänge polymerisiert werden, zusammen mit einer oder mehreren Verbindungen, die nur durch Bestrahlung bei einer kürzeren Wellenlänge polymerisiert werden, enthalten. Ferner können sie auch eine oder mehrere doppelfunktionelle Verbindungen enthalten, das heisst Verbindungen, welche im gleichen Molekül zwei verschiedene polymerisierbare Funktionen haben, wobei eine nur bei einer kürzeren Wellenlänge aktiviert werden kann als die Wellenlänge, bei der die andere aktiviert wird. Das Stoffgemisch kann ferner auch ein Gemisch einer oder mehrerer der oben beschriebenen doppelfunktionellen Verbindungen zusammen mit einer oder mehreren Verbindungen, welche bei der längeren oder der kürzeren Wellenlänge, bei der das doppelfunktionelle Material polymerisiert werden kann, enthalten.

In einer bevorzugten Ausführungsform wird die erste Bestrahlung im sichtbaren Bereich des Spektrums und die zweite Bestrahlung im ultravioletten Bereich durchgeführt. Es können aber auch beide Bestrahlungen unter Verwendung ultravioletter Strahlen verschiedener Wellenlänge durchgeführt werden.

Reste, die durch freie Radikale polymerisiert werden können und als Komponente (A) des flüssigen Stoffgemisches verwendet werden können, sind wohlbekannt und sind vorzugsweise Ester ethylenisch ungesättigter Monocarbonsäuren, Vinylgruppen enthaltende Verbindungen oder Gemische eines Polyens mit einem Polythiol.

Bevorzugte Ester ethylenisch ungesättigter Monocarbonsäuren haben mindestens eine Gruppe der Formel I

$$CH_2 = C(R^1)COO— \qquad (I),$$

worin R Wasserstoff, Chlor oder Brom oder eine Alkylgruppe mit 1 bis 4 Kohlenstoffatomen ist, insbesondere ein Wasserstoffatom oder eine Methylgruppe ist. Geeignete derartige Ester sind z. B. Acrylate und 2-substituierte Acrylate einwertiger Alkohole, z. B. von 2-Methoxyethanol, 2-Cyanoethanol, Furfurylalkohol, Glycidol und Cyclohexanol, sowie Teilester oder Ester mehrwertiger Alkohole, z. B. von Butandiol, Pentaerythit, Dipentaerythrit, Tri- und Tetraethylenglykole, Trimethylolpropan und Glycerin. Geeignet sind auch Ester, die durch Umsetzung eines Alkylenoxids, insbesondere Ethylenoxids oder Propylenoxids, mit einer Acrylsäure erhalten werden, wie z. B. 2-Hydroxyethyl- und 2-Hydroxypropylacrylate und -methacrylate. Es können auch Ester verwendet werden, welche durch Umsetzung einer eine oder mehrere Glycidylgruppen enthaltenden Verbindung, insbesondere eines Mono- oder Polyglycidylethers oder eines ein- oder mehrwertigen Alkohols oder Phenols, oder eines N-Glycidylhydantoins mit Acryl- oder Methacrylsäure hergestellt werden können. Weitere geeignete Verbindungen sind Ester, hergestellt durch Umsetzung eines Diepoxids mit einem Addukt eines Hydroxyalkylacrylats oder eines 2-substituierten Acrylats mit einem gesättigten oder ungesättigten Dicarbonsäureanhydrid, wie z. B. mit Bernstein-, Malein-, oder Phthalsäureanhydrid.

Typische derartige Verbindungen sind z. B. 1,4-Bis (2-hydroxy-3-acryloyloxypropoxy)butan, ein Poly(2-hydroxy-3-acryloyloxypropyl)ether eines Bisphenols oder eines Phenol-Formaldehyd-Novolaks, 2,2-Bis[4-(2-hydroxy-3-(2-acryloyloxyethoxy)succinyloxypropoxy)phenyl]propan, 1-(2-Hydroxy-3-acryloyloxypropoxy)-butan, -octan und -decan, Bis(2-hydroxy-3-acryloyloxypropyl)adipat, 2-Hydroxy-3-acryloyloxypropylpropionat, 3-Phenoxy-2-hydroxypropylacrylat, 2-Hydroxyethylacrylat, 2-Hydroxypropylacrylat, Trimethylolpropantrisacrylat, Pentaerytrittetracrylat und die entsprechenden Methacrylate.

Eine Vielzahl Vinylgruppen enthaltender Verbindungen kann als Komponente (A) des flüssigen Stoffgemisches verwendet werden, wie z. B. Vinyl substituierte aromatische Verbindungen, wie z. B. Styrol, α-Methylstyrol und Vinyltoluol, Vinylester, wie z. B. Vinylacetat, Allylverbindungen, wie z. B. Diallylmaleat und Dimethallylfumarat und Vinyl heterocyclische Verbindungen wie z. B. 2-, 3-, oder 4-Vinylpyridin und 2- oder 3-Vinylpyrrolidin.

Polyene, welche in Gemischen mit Polythiolen als Komponente (A) verwendet werden können, haben

mindestens zwei Gruppen der Formel

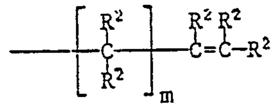

(II)

oder

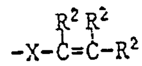

(III)

worin die Gruppen $R^2$, welche gleich oder verschieden sein können, Wasserstoff-, Fluor- und Chloratome sowie Furyl, Thienyl, Pyridyl, Phenyl, substituiertes Phenyl, Benzyl und substituiertes Benzyl, Alkyl, substituiertes Alkyl, Alkoxy und substituiertes Alkoxy mit 1 bis 9 Kohlenstoffatomen und Cycloalkyl und substituiertes Cycloalkyl mit 3 bis 8 Kohlenstoffatomen sein kann, wobei die Substituenten unter Chlor- oder Fluoratomen, Acetoxy-, Nitro-, Acetamido-, Phenyl-, Benzyl-, Alkyl-, Alkoxy- und Cycloalkylgruppen ausgewählt werden können, m eine ganze Zahl von 1 bis 9 ist und X eine Gruppe $-NR^2-$, —O—, oder —S— darstellt.

Polythiole, welche mit diesen Polyenen im Gemisch als Komponente (A) verwendet werden können, haben die allgemeine Formel

$$R^3(SH)_n \qquad (IV),$$

worin $R^3$ eine mehrwertige organische Gruppe darstellt, die keine reaktiven CC Doppelbindungen hat, und n mindestens 2 ist.

Vorzugsweise ist die organische Gruppe $R^3$ eine Alkylengruppe mit 2 bis 10 Kohlenstoffatomen, eine Arylengruppe mit 6 bis 10 Kohlenstoffatomen, eine Alkarylengruppe mit 7 bis 16 Kohlenstoffatomen, eine Cycloalkylengruppe mit 5 bis 10 Kohlenstoffatomen oder eine Cycloalkylalkylengruppe mit 6 bis 16 Kohlenstoffatomen, wobei jede dieser Gruppen substituiert sein kann und Sauerstoffatome oder Estergruppen in den Alkylenketten enthalten kann. Spezifische Beispiele bevorzugter Polythiole sind z. B. Ethylenglykol-bis(thioglykolat, Ethylenglykol-bis(β-mercaptopropionat), Trimethylolpropan-tris(thioglykolat), Trimethylopropantris-(β-mercaptopropionat), Pentaerythrit-tetrakis(thioglykolat), Pentaerythrit-tetrakis(β-mercaptopropionat) und Thioglykolate, β-Mercaptopropionate und 3-Mercapto-2-hydroxypropylether von Polyalkylenglykolen und -triolen, wie z. B. Polypropylenetherglykol-bis(β-mercaptopropionat) und 3-Mercapto-2-hydroxypropylether eines von Glycerin abgeleiteten Polyoxypropylentriols.

Das Molverhältnis der En : Thiol-Gruppen muss so gewählt werden, dass nach der Bestrahlung ein festes Produkt entsteht, wobei Molverhältnisse von 1 : 0,5-2 bevorzugt werden.

Wie vorher erwähnt, wird die Härtung von photohärtbaren Polyen-Polythiol-Gemischen fortgesetzt, auch nachdem die Strahlenquelle entfernt ist, so dass die Verwendung solcher Gemische in Zusammensetzungen, welche bei gleicher Wellenlänge verfestigt werden, bei der auch das Bild erzeugt wird, eine sehr sorgfältige Kontrolle benötigt, und nur einen minimalen Zeitabstand zwischen den zwei Bestrahlungen erlaubt. Im Gegensatz dazu darf im vorliegenden Verfahren die Polyen-Polythiol-Komponente des Gemisches durch die erste Bestrahlung vollständig aushärten, so dass auch langzeitige Lagerung keine Auswirkungen auf das Verfahren hat. Der strahlungshärtbare Rest im Stoffgemisch, welcher bei der für die Härtung des Polyen-Polythiol Gemisches verwendeten Wellenlänge nicht reagiert, wird auch durch langzeitige Lagerung nicht beeinträchtigt. Wenn die Bestrahlung im vorbestimmten Muster bei kürzerer Wellenlänge durchgeführt wird, entsteht immer ein entwickelbares Bild.

Der Polymerisationsinitiator (B), welcher bei Bestrahlung freie Radikale bildet, die den Rest (A) polymerisieren, kann gegen sichtbares oder ultraviolettes Licht empfindlich sein. Solche Initiatoren sind bekannt und umfassen z. B. Benzoinether, Acyloinether, halogenierte Alkyl- oder Arylderivate, aromatische Carbonylderivate, Metallocene, Gemische von organometallischen Verbindungen der Gruppe IVA mit photoreduzierbaren Farbstoffen, Gemische von Chinonen mit aliphatischen Aminen, welche an einem aliphatischen α-Kohlenstoffatom einen Wasserstoffatom haben, aliphatiche Dicarbonylverbindungen, die gegebenenfalls mit einem Amin vermischt sind, 3-Ketocumarine, Acylphosphinoxide, Metallcarbonyle und Gemische photoreduzierbarer Farbstoffe mit Reduktionsreagenzien. Bevorzugte Polymerisationsinitiatoren (B) sind Camphorchinon zusammen mit einem tertiären Amin, das ein Wasserstoffatom am aliphatischen α-Kohlenstoffatom hat, wie z. B. Bis (4-dimethylamino)benzophenon und Triethanolamin, Biacetyl, Dimangandecacarbonyl, Benzildimethylketal, Isobutylbenzoinether, 2,2,2-Trichlor-4'-tert.butylacetophenon, Diethoxyacetophenon, Cumarine mit einer carbocyclischen oder heterocyclischen aromatischen Ketogruppe in der 3-Stellung, wie z. B. 3-Benzoyl-7-methoxycumarin, oder 3-(4-Cyanobenzoyl)-5,7-dipropoxycumarin, Gemische von photoreduzierbaren Farbstoffen, wie z. B. Methylenblau oder Bengalrosa mit einem Stannan wie z. B. Trimethylbenzylstannan, Tributylbenzylstannan, Tributyl-4-methylbenzylstannan oder Dibutyldibenzylstannan, Gemische von photoreduzierbaren Farbstoffen mit einem Elektronendonor, wie z. B. Natriumbenzolsulfinat oder Benzolsulfinsäure und ein Titanmetallocen,

wie z. B. Bis($\pi$-methylcyclopentadienyl)bis($\sigma$-pentafluorphenyl)titan (IV) oder Bis($\pi$-methylcyclopentadienyl)-bis($\sigma$-hexyloxytetrafluorphenyl)titan (IV).

Es werden auch Gemische beschrieben, in welchen der Initiator (B) ein Metallocen oder ein Gemisch einer organometallischer Verbindung der Gruppe IVA mit photoreduzierbaren Farbstoffen ist, die als solche neu sind. Die vorliegende Erfindung betrifft daher neue Stoffgemische, welche im vorliegenden Verfahren verwendet werden können, enthaltend

(A) einen Rest, der durch freie Radikale polymerisierbar ist,

(B) einen strahlungsaktivierbaren Polymerisationsinitiator für (A), der ein Metallocen oder ein Gemisch einer organometallischen Verbindung der Gruppe IVA mit einem photoreduzierbaren Farbstoff ist,

(C) einen strahlungshärtbaren Rest, der verschieden von (A) ist, und gegebenenfalls

(D) einen strahlungsaktivierbaren Katalysator für die Härtung von (C).

Bevorzugte Metallocene, die in den neuen Stoffgemischen verwendet werden, sind Titanocene der Formel

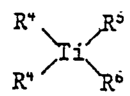

(V)

worin jede der Gruppen $R^4$ unabhängig voneinander eine gegebenenfalls substituierte Cyclopentadienyl- oder Indenylgruppe ist, oder die zwei $R^4$-Gruppen zusammen Alkylidengruppen mit 2 bis 12 Kohlenstoffatomen, eine Cycloalkylidengruppe mit 5 bis 7 Kohlenstoffatomen im Ring, eine Gruppe $Si(R^7)_2$ oder $Sn(R^7)_2$, oder eine gegebenenfalls substituierte Gruppe der Formel

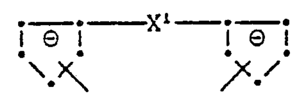

worin $X^1$ Methylen, Ethylen oder 1,3-Propylen bedeutet, darstellen, $R^5$ einen 6-gliedrigen carbocyclischen oder 5- oder 6-gliedrigen heterocyclischen aromatischen Ring bedeutet, der in mindestens einer der ortho-Stellungen zur Metall-Kohlenstoffbindung durch ein Fluoratom substituiert ist, wobei der Ring gegebenenfalls weitere Substituenten aufweisen kann, oder $R^5$ mit $R^6$ zusammen eine Gruppe -Q-Y-Q- bedeuten, und Q für einen 5- oder 6-gliedrigen carbocyclischen oder heterocyclischen aromatischen Ring steht, in welchem jede der zwei Bindungen ortho zur Q-Y Bindung ist und jede Stellung meta zur Q-Y Bindung durch Fluor substituiert ist, wobei die Gruppen Q gegebenenfalls weitere Substituenten haben können, Y eine Methylengruppe, eine Alkylidengruppe mit 2 bis 12 Kohlenstoffatomen, eine Cycloalkylidengruppe mit 5 bis 7 Kohlenstoffatomen im Ring, eine direkte Bindung, eine Gruppe $NR^7$, einen Sauerstoff- oder Schwefelatom, eine Gruppe $—SO_2—$, $—CO—$, $—Si(R^7)_2—$ oder $—Sn(R^7)_2—$ bedeutet, $R^6$ eine Alkinyl- oder Phenylalkinylgruppe, die substituiert sein kann, eine Azido oder Cyanogruppe oder eine Gruppe der Formel $Si(R^7)_2$ oder $Sn(R^7)_2$ oder die gleiche Bedeutung wie die Gruppe $R^5$ hat, und $R^7$ eine Alkylgruppe mit 1 bis 12 Kohlenstoffatomen, eine Cycloalkylgruppe mit 5 bis 12 Kohlenstoffatomen, eine Arylgruppe mit 6 bis 16 Kohlenstoffatomen oder eine Aralkylgruppe mit 7 bis 16 Kohlenstoffatomen ist.

Bei den Gruppen $R^4$ handelt es sich bevorzugt um gleiche Reste. Als Substituenten für durch $R^4$ dargestellte Gruppen kommen in Frage: Lineares und verzweigtes Alkyl, Alkoxy und Alkenyl mit bevorzugt bis zu 18, besonders bis zu 12 und insbesondere bis zu 6 C-Atomen, wie Methyl, Ethyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen; Cycloalkyl und Cycloalkenyl mit bevorzugt 5 bis 8 Ringkohlenstoffatomen, wie z. B. Cyclopentyl, Cyclohexyl, Cycloheptyl, Methylcyclopentyl und Methylcyclohexyl; Aryl mit bevorzugt 6 bis 16 C-Atomen und Aralkyl mit bevorzugt 7 bis 16 C-Atomen; wie z. B. Phenyl, Naphthyl, Biphenyl, Benzyl und Phenylethyl; Nitril, Halogen, besonders F, Cl und Br, sowie Aminogruppen, besonders tertiäre Aminogruppen, die lineare oder verzweigte Alkylgruppen mit 1 bis 12, besonders 1 bis 6 C-Atomen und insbesondere Methyl und Ethyl, Phenyl und Benzyl enthalten können. Die Aminogruppen können auch quaternisiert sein, besonders mit linearen oder verzweigten Alkylhalogeniden mit vorzugsweise 1 bis 12 C-Atomen, besonders Methyl- oder Ethylhalogeniden; lineares oder verzweigtes Aminoalkyl, besonders tertiäres Aminoalkyl, das auch quaternisiert sein kann, besonders mit Alkylhalogeniden. Die Alkylengruppe im Aminoalkyl kann linear oder verzweigt sein und enthält bevorzugt 1 bis 12, insbesondere 1 bis 6 C-Atome und ist ganz besonders $\alpha$-verzweigtes Alkyl mit 1-12 C-Atomen.

Die Reste $R^4$ können bis zu 3, besonders aber 1, Substituenten enthalten. Insbesondere sind beide $R^4$ Cyclopentadienyl⊖ oder Methycyclopentadienyl⊖.

Alkylidengruppen $X^1$ und Y enthalten bevorzugt 2 bis 6 C-Atome. Beispiele für Alkylidengruppen und Cycloalkylidengruppen $X^1$ und Y sind Ethyliden, 2,2-Propyliden, Butyliden, Hexyliden, Phenylmethylen, Diphenylmethylen, Cyclopentyliden und Cyclohexyliden. Besonders bevorzugt ist $X^1$ Methylen. $R^7$ in

seiner Bedeutung als Alkyl enthält bevorzugt 1 bis 6 C-Atome und ist z. B. Methyl, Ethyl, Propyl, Butyl oder Hexyl. In seiner Bedeutung als Cycloalkyl ist $R^7$ bevorzugt Cyclopentyl oder Cyclohexyl, in seiner Bedeutung als Aryl bevorzugt Phenyl und in seiner Bedeutung als Aralkyl bevorzugt Benzyl.

Der Rest $R^5$ ist bevorzugt in beiden Orthostellungen durch Fluor substituiert.

Bei $R^5$ in seiner Bedeutung als carbocyclischer aromatischer und fluor-substituierter Ring kann es sich um Inden, Indan, Fluoren, Naphthalin und besonders Phenyl handeln. Beispiele sind : 4,6-Difluorinden-5-yl, 5,7-Difluorinden-6-yl, 2,4-Difluorfluoren-3-yl, 1,3-Difluornaphth-2-yl und besonders 2,6-Difluorphen-1-yl.

$R^5$ als heterocyclischer aromatischer und 5-gliedriger Ring enthält bevorzugt ein Heteroatom und als 6-gliedriger Ring bevorzugt 1 oder 2 Heteroatome. Beispiele für solche mit 2-Fluoratomen substituierte Ringe sind : 2,4-Difluorpyrrol-3-yl, 2,4-Difluorfur-3-yl, 2,4-Difluortiophen-3-yl, 2,4-Difluorpyrid-3-yl, 3,5-Difluorpyrid-4-yl und 4,6-Difluorpyrimid-5-yl.

$R^5$ und $R^6$ zusammen als Gruppe -Q-Y-Q- können z. B. sein :

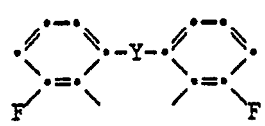 , 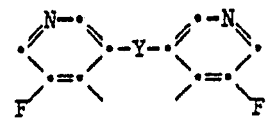 ,

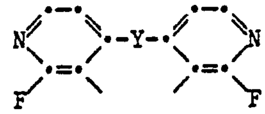 , 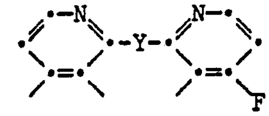 ,

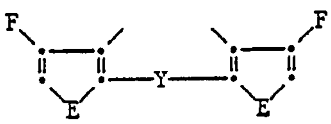 und 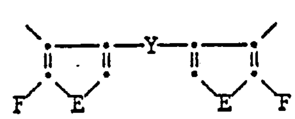 ,

worin E O, S oder NH darstellt. Y ist bevorzugt Methylen, Ethyliden, 2,2-Propyliden, eine direkte Bindung oder O.

Die Reste $R^5$ sowie die Gruppen Q in -Q-Y-Q- können teilweise oder vollständig durch weitere Gruppen substituiert sein. Geeignete Gruppen sind : Lineares oder verzweigtes Alkyl oder Alkoxy mit bevorzugt 1 bis 18, insbesondere 1 bis 6 C-Atomen, z. B. Methyl, Ethyl, Propyl, Butyl, Pentyl, Hexyl und die entsprechenden Alkoxygruppen, besonders Methoxy und Hexyloxy ; Cycloalkyl mit bevorzugt 5 oder 6 Ringkohlenstoffatomen, Aryl mit bevorzugt 6 bis 16 C-Atomen und Aralkyl mit bevorzugt 7 bis 16 C-Atomen, wie z. B. Cyclopentyl, Cyclohexyl, Phenyl oder Benzyl ; Hydroxyl, Carboxyl, CN, Halogen, wie F, Cl oder Br, und Aminogruppen, besonders tertiäre Aminogruppen, die mit Alkylhalogeniden, wie Methylchlorid, -bromid oder -iodid, quaternisiert sein können. Beispiele für Aminogruppen sind Methylamino, Ethylamino, Dimethylamino, Diethylamino, Pyrrolidyl, Piperidyl, Piperazyl, Morpholyl und N-Methylpiperazyl ; Alkoxycarbonyl mit bevorzugt 1 bis 18, besonders 1 bis 6 C-Atomen in der Alkoxygruppe, Aminocarbonyl mit ein oder zwei Alkylgruppen mit 1 bis 12 C-Atomen in der Aminogruppe, oder Aminocarbonyl mit heterocyclischen Aminen, wie Pyrrolidin, Piperidin, Piperazin, N-Methylpiperazin und Morpholin ; Aminoalkyl, besonders tertiäres Aminoalkyl mit bevorzugt $C_1$-$C_6$-Alkylgruppen, das mit Alkylhalogeniden quaternisiert sein kann. Bevorzugt ist Tertiäraminomethyl, das durch Alkyl mit 1 bis 6 C-Atomen substituiert sein kann. Beispiele sind Dimethylaminomethyl und (Trimethylammonium-methyl) iodid.

Stellt $R^6$ Alkinyl dar, so handelt es sich z. B. um 2-Butinyl und vor allem um Propargyl.

Substituenten für $R^6$ als Phenylalkinyl sind z. B. Halogen, wie F, Cl und Br, Alkyl und Alkoxy mit 1-6 C-Atomen, —COOH, —OH und —CN. $R^6$ hat bevorzugt die Bedeutung von $R^5$.

In einer bevorzugten Ausführungsform sind $R^5$ und $R^6$ in Formel V unsubstituiertes oder substituiertes 2,6-Difluorphen-1-yl oder $R^5$ und $R^6$ bilden zusammen einen Rest der Formel

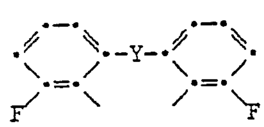 ,

worin Y die oben angegebene Bedeutung hat und insbesondere eine direkte Bindung, $CH_2$ oder O ist.

Eine bevorzugte Gruppe von Metallocenen der Formel V sind solche, worin beide $R^4$ $\pi$-Cyclopentadienyl oder durch $C_1$-$C_4$-Alkyl, besonders Methyl, substituiertes $\pi$-Cyclopentadienyl und $R^5$ und $R^6$ je ein Rest der Formel Va

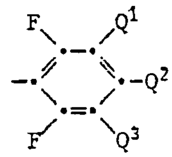 Va

sind, worin $Q^1$, $Q^2$ und $Q^3$ unabhängig voneinander für ein Wasserstoffatom, F, Cl, Br oder eine tertiäre Aminogruppe, besonders eine Morpholinogruppe oder eine Alkoxygruppe, besonders eine Methoxy-oder Hexyloxygruppe, stehen. Die Amino- oder Alkoxygruppe ist bevorzugt in para-Stellung zur freien Bindung gebunden. Eine bevorzugte Untergruppe sind Metallocene der Formel V, worin beide $R^4$ $\pi$-Methylcyclopentadienyl oder $\pi$-Cyclopentadienyl darstellen und $R^5$ und $R^6$ je ein Rest der Formel Va sind, worin $Q^1$ und $Q^3$ für H, F, Cl oder Br und $Q^2$ für H, F oder Alkoxy stehen. Besonders bevorzugt sind $Q^1$ und $Q^3$ unabhängig voneinander ein Wasserstoff- oder Fluoratom und $Q^2$ ist ein Fluoratom oder ein Hexyloxyrest.

Verbindungen der Formel V sowie deren Herstellung sind in der australischen Patentschrift No. 84 24454 beschrieben.

Bevorzugte organometallische Verbindungen der Gruppe IVA, welche in den neuen Stoffgemischen verwendet werden, sind Organostannane der Formel VI

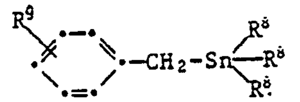 (VI)

worin $R^8$ eine Alkylgruppe mit 1 bis 4 Kohlenstoffatomen oder eine Alkenyl- der Alkynylgruppe mit 2 bis 4 Kohlenstoffatomen und $R^9$ ein Wasserstoff- oder Halogenatom oder eine Alkyl- oder Alkoxygruppe mit 1 bis 4 Kohlenstoffatomen sind.

Bevorzugte Verbindungen der Formel VI sind jene, worin $R^8$ eine Alkylgruppe mit 1 bis 4 Kohlenstoffatomen und $R^9$ ein Wasserstoffatom oder eine Alkylgruppe mit 1 bis 4 Kohlenstoffatomen bedeuten.

Diese Organostannane werden durch eine Grignard Verknüpfung eines Benzylmagnesiumhalogenids mit einem Trialkylzinnhalogenid in einem inerten Lösungsmittel hergestellt, gefolgt von Filtration, Waschen mit Wasser und Destillation des Produkts.

Bevorzugte photoreduzierbare Farbstoffe, welche mit diesen Organostannanen verwendet werden, sind Methylenblau und Bengalrosa.

Der strahlungshärtbare Rest (C) kann entweder durch direkte Strahlungsaktivierung der photoempfindlichen Gruppen, oder durch Aktivierung der polymerisierbaren Gruppen mit einem geeigneten Katalysator (D), welcher selber durch die Strahlung aktiviert wird, polymerisiert werden.

Stoffe, welche photoempfindliche Gruppen haben, sind wohlbekannt und umfassen solche, die mindestens zwei, vorzugsweise drei oder mehrere Azido-, Cumarin-, Stilben-, Maleinimido-, Pyridinon-, Chalcon-, Propenon-, Pentadienon-, Anthracen- oder Acrylestergruppen, welche in der 3-Stellung durch eine Gruppe mit ethylenischen Doppelbindungen oder Aromaticität in Konjugation mit der ethylenischen Doppelbindung der Acrylgruppen aufweisen, haben.

Stoffe, deren Photopolymerisation durch Aktivierung eines Photoinitiators, welcher dann die polymerisierbaren Gruppen aktiviert, verursacht wird, umfassen Epoxidharze, Phenolharze, cyclische Ether, Vinylether, cyclische Ester, cyclische Sulfide, cyclische Amine und cyclische Organosiliciumverbindungen in Kombination mit einem strahlungsempfindlichen aromatischen Oniumsalz, wie z. B. einem Diazonium-, Sulfonium-, Iodonium und Sulfoxoniumsalz, oder einem strahlungsempfindlichen aromatischen Iodosylsalz.

Beispiele geeigneter Azide sind Verbindungen, welche mindestens zwei Gruppen der Formel

$$N_3Ar— \quad (VII)$$

enthalten, worin Ar einen ein- oder zweikernigen zweiwertigen aromatischen Rest mit insgesamt 6 bis höchstens 14 Kohlenstoffatomen, insbesondere eine Phenylen- oder Naphthylengruppe, bedeutet.

Beispiele geeigneter Cumarine sind Verbindungen der Formel

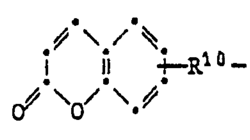 (VIII)

worin $R^{10}$ ein Sauerstoffatom, eine Carbonyloxygruppe (—COO—), eine Sulfonylgruppe oder eine Sulfonyloxygruppe ist.

Beispiele von Verbindungen, welche Stilbengruppen enthalten, sind solche mit Gruppen der Formel

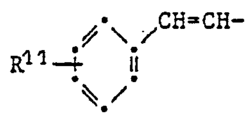

(IX)

worin $R^{11}$ ein Rest mit bis zu 8 Kohlenstoffatomen ist, welcher einen 5- oder 6-gliedrigen stickstoffenthaltenden heterocyclischen Ring, kondensiert auf einen Benzol- oder Naphthalinkern darstellt, der an den erwähnten Benzolkern durch einen dem Stickstoffatom des heterocyclischen Rings benachbarten Kohlenstoffatom gebunden ist, wie z. B. ein Benzimidazolyl-, Benzoxazolyl-, Benzotriazolyl-, Benzothiazolyl-, oder ein Naphthotriazolylrest.

Beispiele von Verbindungen, welche Maleinimideinheiten enthalten, sind solche mit Gruppen der Formel

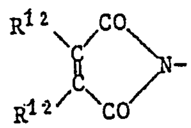

(X)

worin jedes $R^{12}$ eine Alkylgruppe mit 1 bis 4 Kohlenstoffatomen, ein Chloratom oder eine Phenylgruppe, und insbesondere eine Methylgruppe ist.

Beispiele von Verbindungen, welche Pyridinoneinheiten enthalten, sind solche mit Gruppen der Formel

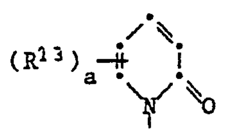

(XI)

worin $R^{13}$ ein aliphatischer oder cycloaliphatischer Rest mit 1 bis 8 Kohlenstoffatomen und a null oder eine ganze Zahl von 1 bis 4 ist.

Beispiele von Verbindungen, welche Chalcon-, Propenon- und Pentadienongruppen enthalten, sind solche mit Gruppen der Formel

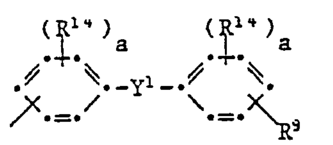

oder

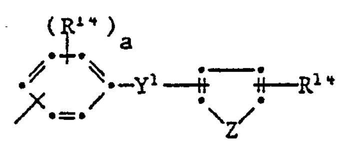

,

XII

XIII

worin jedes $R^{14}$ ein Halogenatom oder eine Alkyl-, Cycloalkyl-, Alkenyl-, Cycloalkenyl-, Alkoxy-, Cycloalkoxy-, Alkenoxy-, Cycloalkenoxy-, Carbalkoxy-, Carbocycloalkoxy-, Carbalkenoxy-, oder Carbocycloalkenoxygruppe ist, wobei diese organische Gruppen 1 bis 9 Kohlenstoffatome enthalten, oder eine Nitrogruppe oder eine Carboxyl, Sulfon- oder Phosphorsäuregruppe in der Form eines Salzes ist, a die vorher angegebene Bedeutung hat, $R^{15}$ eine einfache Bindung oder einen Wasserstoffatom bedeutet, $Y^1$ eine Gruppe der Formel

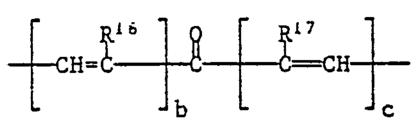

,

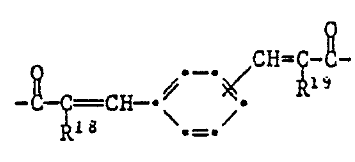

XIV

XV

oder

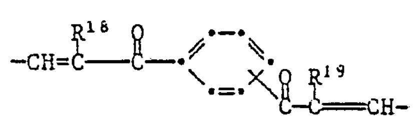

XVI

ist;

$R^{16}$ und $R^{17}$ sind jeweils ein Wasserstoffatom, eine Alkylgruppe, z. B. mit 1 bis 4 Kohlenstoffatomen, oder eine Arylgruppe, vorzugsweise eine einkernige Gruppe wie z. B. eine Phenylgruppe, oder $R^{16}$ und $R^{17}$ zusammen bedeuten eine Polymethylenkette mit 2 bis 4 Methylengruppen, $R^{18}$ und $R^{19}$ sind jeweils ein Wasserstoffatom, eine Alkylgruppe, z. B. mit 1 bis 4 Kohlenstoffatomen, oder eine Arylgruppe, welche vorzugsweise eine einkernige Gruppe, wie eine Phenylgruppe ist, b und c sind jeweils null, 1 oder 2, mit der Massgabe, dass nicht beide null sind, und Z ist ein Sauerstoff- oder Schwefelatom.

Geeignete Anthracene sind solche, welche Anthrylgruppen enthalten, wie z. B. 1-, 2-, oder 9-Anthrylgruppen, die unsubstituiert sind, oder einen oder zwei Brom-, Chlor-, Methyl-, oder Nitrosubstituenten haben.

Geeignet 3-substituierte Acrylate enthalten Gruppe der allgemeinen Formel

$$R^{20}CH = C(R^{21})COO— \qquad XVII,$$

worin $R^{20}$ eine aliphatische oder einkernige aromatische, araliphatische oder heterocyclische Gruppe ist, welche wie bereits erwähnt, ethylenisch ungesättigte Gruppen oder Aromatizität in Konjugation mit der gezeigten ethylenischen Doppelbindung aufweist, wie z. B. eine Phenyl-, 2-Furyl-, 2- oder 3-Pyridyl-, Prop-2-enyl- oder Styrylgruppe und $R^{21}$ ein Wasserstoff- oder Chloratom oder eine Methyl oder Ethylgruppe ist.

Typische Epoxidharze, die als Komponente (C) verwendet werden können, sind Polyglycidylester, welche durch eine Reaktion einer zwei oder mehrere Carboxylsäuregruppen pro Molekül enthaltender Verbindung mit Epichlorhydrin oder Glycerindichlorhydrin in Anwesenheit einer Base erhältlich sind. Solche Glycidylester werden vorzugsweise von aliphatischen Di- und Polycarbonsäuren, wie z. B. Bernsteinsäure, Glutarsäure, Adipinsäure, Pimelinsäure, Suberinsäure, Azaleinsäure, Sebacinsäure oder dimerisierte oder trimerisierte Linolensäure ; von cycloaliphatischen Di- und Polycarbonsäuren, wie z. B. 1,2-Cyclohexandicarbonsäure, und von aromatischen Di- und Polycarbonsäuren, wie z. B. Phthalsäure, Isophthalsäure und Terephthalsäure, abgeleitet.

Weitere Beispiele sind Di- und Polyglycidylether, erhältlich durch Umsetzung einer zwei oder mehrere freie alkoholische Hydroxyl- und/oder phenolische Hydroxylgruppen pro Molekül enthaltender Verbindung mit Epichlorhydrin unter basischen Bedingungen, oder in Anwesenheit eines sauren Katalysators und Nachbehandlung mit Base. Diese Ether können ausgehend von acyclischen Alkoholen, wie z. B. Ethylenglykol, Poly(oxyethylen)glykolen, Propan-1,2-diol, Poly-(oxypropylen)glykolen, Propan-1,3-diol, Butan-1,4-diol, Poly-(oxytetramethylen)glykolen, Glycerin, Pentaerythrit und Poly-(epichlorhydrin) hergestellt werden. Sie können auch von ein- und mehrkernigen Phenolen, wie z. B. Resorcin, Bis(4-hydroxyphenyl)-methan (Bisphenol F), 4,4'-Dihydroxydiphenyl, Bis(4-hydroxyphenyl)-sulfon, 1,1,2,2-Tetrakis(4-hydroxyphenyl)ethan, 2,2-Bis(4-hydroxyphenyl)propan (Bisphenol A), 2,2-Bis(3,5-dibrom-4-hydroxyphenyl)-propan, und von Novolaken, erhalten aus Aldehyden, wie Formaldehyd, durch Umsetzung mit einem Phenol, abgeleitet werden.

Weitere geeignete Komponenten (C) sind Poly(N-glycidyl) verbindungen, wie z. B. solche erhalten durch Dehydrochlorierung der Reaktionsprodukte von Epichlorhydrin mit Aminen, welche mindestens zwei Aminwasserstoffatome enthalten, wie z. B. Anilin, n-Butylamin, und Bis(4-aminophenyl)methan ; Triglycidylisocyanurat und N,N'-Diglycidylderivate von cyclischen Alkylenharnstoffen, wie z. B. Ethylenharnstoff, und von Hydantoinen, wie z. B. 5,5-Dimethylhydantoin.

Epoxidharze, in welchen manche oder alle der Epoxidgruppen nicht endständig sind, können auch verwendet werden, wie z. B. Vinylcyclohexendioxid, Limonendioxid, Dicyclopentadiendioxid, 4-Oxatetracyclo-[6.2.1.$0^{2,7}$ · $0^{3,5}$ ·]undec-9-yl-glycidylether, der Bis(4-oxatetracyclo[6.2.1.$0^{2,7}$ · $0^{3,5}$]undec-9-yl)ether von Ethylenglykol, 3,4-Epoxycyclohexylmethyl-3',4'-epoxycyclohexancarboxylat und dessen 6,6'-Dimethylderivat, das Bis(3,4-epoxycyclohexancarboxylat) von Ethylenglykol, 3-(3,4-Epoxycyclohexyl)-8,9-epoxy-2,4-dioxaspiro[5,5]undecan und epoxidierte Butadiene oder Copolymere von Butadien mit ethylenisch ungesättigten Verbindungen, wie z. B. Styrol und Vinylacetat. Falls gewünscht, kann auch ein Gemisch der Verbindungen (C) verwendet werden.

Besonders bevorzugte Epoxidharze, welche als Komponente (C) im erfindungsgemässen Verfahren verwendet werden, sind Diglycidylether zweiwertiger Phenole, wie z. B. 2,2-Bis(4-hydroxyphenyl)propan und Bis(4-Hydroxyphenyl)methan und zweiwertiger Alkohole, wie z. B. Butan-1,4-diol, Polyglycidylether von Novolaken, insbesondere von Kresol-Formaldehyd-Novolaken und cycloaliphatische Epoxidharze, wie z. B. 3,4-Epoxycyclohexylmethyl-3',4'-epoxycyclohexancarboxylat und 1,4-Bis(3,4-epoxycyclohexylmethyl)butandicarboxylat.

Oniumsalze, welche in Kombination mit einem Epoxidharz oder anderen kationisch polymerisierbaren Verbindungen photopolymerisierbare Gemische bilden, werden in den U.S. Patentschriften 4 058 400 und 4 058 401 beschrieben. Geeignete Sulfoxoniumsalze, welche zum gleichen Zweck verwendet werden können, sind in den U.S. Patentschriften 4 299 938, 4 339 567 und 4 383 025 offenbart. Iodoniumsalze, welche auch zu diesem Zweck verwendet werden können, sind in der GB Patentschrift 1 516 352 beschrieben. Iodosylsalze, die verwendet werden können, sind in der EP Patentschrift 0 104 143 beschrieben.

Falls gewünscht, können der durch freie Radikale polymerisierbare Rest (A) und der strahlungshärtbare Rest (C) ein Teil desselben Moleküls sein, d. h. sie können einen doppelfunktionellen Stoff bilden.

Bevorzugte doppelfunktionelle Stoffe sind die, welche einen Ester einer ethylenisch ungesättigten Monocarbonsäure, insbesondere eine Estergruppe der Formel I, und eine Epoxidgruppe enthalten. Es können auch Verbindungen verwendet werden, welche eine Estergruppe einer ungesättigten Carbonsäure und eine Anthrylgruppe enthalten.

Die doppelfunktionellen Stoffe des ersten Typs können durch Umsetzung einer ungesättigten Monocarbonsäure mit einem stöchiometrischen Unterschuss eines Di- oder Polyepoxids hergestellt werden. Die doppelfunktionellen Stoffe des zweiten Typs können durch Umsetzung einer Verbindung, welche sowohl eine 1,2-Epoxidgruppe als auch eine ungesättigte Estergruppe enthält, mit einer Anthrylverbindung, die mit einer 1,2-Epoxidgruppe reagieren kann, wie z. B. eine Carbonsäure, phenolische oder alkoholische Hydroxylgruppe oder Imidgruppe. Ein doppelfunktioneller Stoff des dritten Typs kann ein Allylepoxidharz sein, hergestellt zum Beispiel durch Glycidylierung eines allylsubstituierten Phenols. Die Umsetzung von Epoxiden mit ungesättigten Säuren ist bekannt. Die Umsetzung von Epoxiden mit geeigneten Anthrylverbindungen ist in der U.S. 4 413 052 beschrieben.

Das Gewichtsverhältnis des durch freie Radikale polymerisierbaren Materials (A) und des strahlungshärtbaren Restes (C) ist für das Gelingen des vorliegenden Verfahrens nicht ausschlaggebend, solange wirksame Mengen beider Komponenten verwendet werden. Wenn (A) und (C) nicht im gleichen Molekül sind, ist das Gewichtsverhältnis von (A) : (C) im allgemeinen im Bereich von 1 : 0,1-10, insbesondere 1 : 1-5. Die Menge des Polymerisationsinitiators (B), der verwendet wird, ist auch nicht kritisch, solange sie ausreicht um die Polymerisation von (A) in der ersten Bestrahlungsstufe zu initiieren. Typische Mengen von (B) sind im Bereich von 0,1-50 Gewichtsteilen (B), insbesondere 0,2 bis 10 Gewichtsteilen, pro 100 Gewichtsteile (A).

Als Lichtquellen eignen sich z. B. Kohlebögen, Quecksilberdampflampen, fluoreszierende Lampen mit ultraviolettem Licht emittierenden Phosphoren, Argon- und Xenonglühlampen, Wolframlampen und photographische Flutlichtlampen. Es ist wichtig, dass die erste Bestrahlung bei längerer Wellenlänge erfolgt als die zweite. Es kann von Vorteil sein, Filter zu verwenden, um kurzwellige Strahlung auszuschliessen, so dass auf diese Art auch eine einzelne Lichtquelle breiten Spektrums verwendet werden kann. Wenn eine derartige einzelne Lichtquelle verwendet wird, wird die erste Belichtung durch ein Filter durchgeführt welcher kurzwellige Strahlen absorbiert, so dass nur der Rest (A) polymerisiert wird. In der zweiten Belichtung kann das ganze unfiltrierte Spektrum der Lichtquelle verwendet werden, so dass die kurzwellige Strahlung die Härtung des Restes (C) verursacht.

Die vorliegenden Stoffgemische können als Flüssigkeiten auf Substrate, wie Stahl, Aluminium, Kupfer, Papier, Silicium oder Kunststoffe, appliziert werden. Nach dem Auftragen des Ueberzugs, findet die erste Belichtung statt, welche in einer Verfestigung des Gemisches resultiert. Das beschichtete Substrat ist dann stabil und kann für längere Zeitabschnitte unter Ausschluss kurzwelliger Beleuchtung gelagert werden. Wenn gewünscht, wird das beschichtete Substrat im vorbestimmten Muster einer Bestrahlung kürzerer Wellenlänge als bei der ersten Belichtung ausgesetzt. Die Teile des Ueberzugs, welche das zweite Mal nicht belichtet wurden, können dann entfernt werden, üblicherweise durch Waschen mit einem geeigneten Lösungsmittel, wie z. B. mit Cyclohexanon, 2-Ethoxyethanol, Diethylenglykolmonobutylether, γ-Butyrolacton, Toluol, Aceton, Propylencarbonat, 1,1,1-Trichlorethan und Gemischen dieser Lösungsmittel, sowie mit wässrigen Lösungsmitteln, wie z. B. verdünntem wässrigem Natriumcarbonat oder Natriumhydroxid. Es kann auch trocken, z. B. mit Plasmaätzung, entwickelt werden. So kann das vorliegende Verfahren durch Anwendung wohlbekannter Verfahrensschritte für die Herstellung von Leiterplatten und gedruckten Schaltungen verwendet werden.

Die folgenden Beispiele illustrieren die Erfindung. Alle Teile sind Gewichtsteile. Die in den Beispielen verwendeten Harze sind :

Harz 1 : Ein epoxidierter o-Kresol-Novolak mit einem Erweichungspunkt von 99 °C und einem Epoxidgehalt von 4,2 Aequivalenten/kg.

Harz 2 : 2-Hydroxyethylmethacrylat.

Harz 3 : 1,4-Bis (3,4-epoxycyclohexylmethyl)butandicarboxylat, mit einem Epoxidgehalt von 4,8 Aequivalenten/kg.

Harz 4 : Trimethylolpropantrismethacrylat.

Harz 5 : Dieses Harz wird wie folgt hergestellt : Bisphenol A-Diglycidylether (250 g) wird auf 120 °C erhitzt und ein Gemisch von Acrylsäure (94,9 g), Chrom(III)trisoctanoat (0,16 g ; 5 %ige Lösung in Ligroin) und 2,6-Di-tert.butyl-4-methylphenol (0,5 g) wird unter Rühren dazugetropft. Das Gemisch wird weitere 5 Stunden erhitzt, und der Epoxidgehalt des Gemisches ist danach vernachlässigbar. Das erhaltene Produkt ist 2,2-Bis [4-(3-acryloyloxy-2-hydroxypropoxy)-phenyl]propan.

Harz 6 : Anthracen-9-carbonsäure (4 g) wird einem Gemisch aus Glycidylmethacrylat (2,8 g), Tetramethylammoniumchlorid (0,1 g) und 2,6-Di-tert.butyl-4-methylphenol (0,1 g) bei 100 °C beigegeben. Das Gemisch wird während 4 Stunden bei 100 °C gerührt, und der Epoxidgehalt ist danach vernachlässig-

bar. Das Produkt, Harz 6, ist 2-Hydroxy-3-methacryloyloxypropylathracen-9-carboxylat.

Harz 7 : 3,4-Epoxycyclohexylmethyl-3',4'-epoxycyclohexancarboxylat.

Harz 8 : Hergestellt nach dem im J. Polym. Sci. Polym. Chem. (1983) 21 1785, beschriebenen Verfahren : Ein Gemisch aus Bisphenol A (45,6 g, 0,2 Mol), Natriumhydroxidpulver (24 g, 0,6 Mol) und Dimethylsulfoxid (DMSO) (75 ml) wird bei 70 °C eine Stunde unter Stickstoff erhitzt. 2-Chlorethylvinylether (64 g, 0,6 Mol) wird während 30 Minuten zugetropft, und die Temperatur wird unter 80 °C gehalten. Nach Beendigung der Zugabe werden weitere 25 ml DMSO beigegeben und das Gemisch wird 5 Stunden bei 70 °C gerührt, abgekühlt und in 100 ml Wasser gegossen. Es entsteht eine ölige Schicht, welche in Diethylether (60 ml) gelöst wird. Die Etherlösung wird mit Wasser (3 × 50 ml) gewaschen, über wasserfreies Magnesiumsulfat getrocknet und auf einem Rotationsverdampfer eingedampft. Das hellgelbe Oel wird aus 95 %igem Ethanol umkristallisiert, wobei 59,8 g 2,2-Bis (4-vinyloxyethoxyphenyl) propan erhalten werden. IR (KBr-Pastille) 3070, 3050, 2980, 2950, 2939, 2880, 1620, 1511, 1453, 1322, 1251, 1209, 1075, 982, 841 und 821 $cm^{-1}$. NMR (Aceton-$D_6$) 1,65 (s, 6H), 3,8-4,5 (m, 12H), 6,5-7,5 (m, 10H)δ.

Harz 9 : Trimethylolpropantrisacrylat.

Harz 10 : Tris(3-mercapto-2-hydroxypropyl)ether eines vom Glycerin abgeleiteten Polyoxypropylentriols mit einem durchschnittlichen Molekulargewicht von 800.

Harz 11 : 2,2-Bis (3-allyl-4-hydroxyphenyl)propan-Diglycidylether mit einem Epoxidgehalt von 4,5 Equivalenten/kg.

Das in den Beispielen 11 und 14 verwendete Dimethyltricyclo[3.3.1.1.$^{3,7}$]decan-1-carbonylmethylsulfoxoniumhexafluorphosphat wird nach dem in der EP-A-0 164 314 beschriebenen Verfahren hergestellt.

## Beispiel 1

Ein Gemisch aus Harz 1 (27,5 Teile), Harz 2 (11 Teile) und Harz 3 (10 Teile) wird einem Gemisch von Bengalrosa (0,05 Teile), Tri-n-butyl-benzyl-stannan (5 Teile) und Triphenylsulfoniumhexafluorphosphat beigegeben und gerührt bis das Gemisch homogen ist. Das Gemisch wird auf ein kupferkaschiertes Laminat als eine 15 µm dicke Schicht aufgetragen. Das Laminat wird mit einer 500 W Wolframhalogenlampe, welche Strahlen einer Wellenlänge über 400 nm emitiert, während 3 Minuten aus einer Entfernung von 200 nm belichtet, wonach der Ueberzug fest und nicht klebrig ist. Der verfestigte Ueberzug wird dann durch ein Dia mit einer 5 000 W Metallhalogenidlampe einer Wellenlänge von 340-450 nm aus einer Entfernung von 750 mm während 3 Minuten belichtet. Entwicklung in γ-Butyrolacton gibt ein Negativbild des Dias.

## Beispiel 2

Ein Gemisch aus Harz 1 (27,5 Teile), Harz 2 (11 Teile), Harz 3 (10 Teile) und Harz 4 (1,4 Teile) wird einem Gemisch von Methylenblau (0,05 Teile) Tri-n-butyl-benzyl-stannan (5 Teile) und Triphenylsulfoniumhexafluorphosphat (5 Teile) beigegeben und gerührt bis eine homogene Lösung erhalten wird. Das Gemisch wird auf ein kupferbeschichtetes Laminat zu einer 15 µm dicken Schicht aufgetragen, und der Ueberzug wird durch Bestrahlung mit einer 500 W Wolframhalogenlampe aus einer Entfernung von 200 mm während 3 1/2 Minuten verfestigt. Der feste Ueberzug wird dann durch ein Dia mit einer 5 000 W Metallhalogenidlampe aus einer Entfernung von 750 mm während 3 Minuten belichtet. Entwicklung mit γ-Butyrolacton gibt ein Negativbild des Dias.

## Beispiel 3

Harz 1 (6,5 Teile), Harz 2 (3,5 Teile), Harz 3 (1 Teil) und Harz 5 (1 Teil) werden gemischt, und das Gemisch wird mit Bengalrosa (0,02 Teile), Di-n-Butyldiphenylstannan (0,3 Teile) vermischt. Das Gemisch wird zu einer 6-8 µm dicken Schicht auf ein kupferkaschiertes Laminat aufgetragen und durch Belichtung mit einer 400 W Metallhalogenidlampe bei einer Wellenlänge von 420 nm, aus einer Entfernung von 400 mm während 4 Minuten belichtet. Der verfestigte Ueberzug wird dann durch ein Dia mit einer Metallhalogenidlampe bei einer Wellenlänge von 313 nm aus einer Entfernung von 750 mm während 3 Minuten belichtet. Entwicklung mit γ-Butyrolacton gibt ein Negativbild des Dias.

## Beispiel 4

Harz 1 (65 Teile) und Harz 2 (35 Teile) werden mit Triphenylsulfoniumhexafluorphosphat (5 Teile) und Bis(π-methylcyclopentadienyl)bis(σ-pentafluorphenyl)titan (IV) (1 Teil) in Aceton (1 Teil) gemischt. Das Gemisch wird auf ein kupferkaschiertes Laminat als eine 30 µm dicke Schicht aufgetragen und während einer Minute unter Stickstoff mit der im Beispiel 1 beschriebenen 500 W Wolframhalogenidlampe aus

einer Entfernung von 200 mm belichtet. Der verfestigte nichtklebrige Ueberzug wird dann durch ein Dia mit der im Beispiel 1 beschriebenen 5 000 W Metallhalogenidlampe während 4 Minuten aus einer Entfernung von 750 mm belichtet. Entwicklung in einem 3 : 1 Gemisch aus γ-Butyrolacton und Butyldigol (Diethylenglykolmonobutylether) ergibt ein scharfes glänzendes Negativbild des Dias. Das Laminat kann mit einer wässrigen Lösung von Eisen(III)-chlorid (40 % $FeCl_3$) bei 30 °C während 3 1/2 Minuten geätzt werden, ohne dass das Bild beeinträchtigt wird.

Beispiel 5

Beispiel 4 wird wiederholt, indem Triphenylsulfoniumhexafluorphosphat durch die gleiche Menge Diphenyliodoniumhexafluorphosphat ersetzt wird. Belichtung durch ein Dia während 5 Minuten ergibt ein klares Negativbild des Dias.

Beispiel 6

Harz 6 (85 Teile), Harz 2 (15 Teile) und Bis(π-methylcyclopentadienyl)bis(σ-pentafluorphenyl)titan (IV) (1 Teil) werden gemischt und auf ein kupferkaschiertes Laminat in einer Schichtdicke von 15 μm aufgetragen. Der Ueberzug wird unter Stickstoff mit der im Beispiel 1 beschriebenen 500 W Wolframhalogenidlampe aus einer Entfernung von 200 mm während 5 Minuten belichtet. Der Ueberzug wird fest und klebfrei. Der verfestigte Ueberzug wird dann durch eine Dia mit einer 80 W pro cm Mitteldruckquecksilberlampe bei einer Wellenlänge von 200-400 nm aus einer Entfernung von 250 mm während 1 1/2 Minuten belichtet.

Entwicklung in Toluol ergibt ein Negativbild des Dias.

Beispiel 7

Beispiel 4 wird wiederholt, aber um zu zeigen, dass eine Ueberbelichtung bei der ersten Belichtung nicht schädlich ist, wird die erste Belichtung während 1 Minute durchgeführt, um einen festen nichtklebrigen Ueberzug zu geben, wonach die Belichtung während weiteren 5 Minuten fortgesetzt wird. Die zweite Belichtung wird dann, wie im Beispiel 4 beschrieben, durchgeführt. Entwicklung in einem 3 : 1 Gemisch aus γ-Butyrolacton und Butyldigol ergibt ein Bild der gleichen Qualität wie das mit Beispiel 4 erhaltene Bild.

Beispiel 8

Das im Beispiel 4 verwendete Gemisch wird in einer Schichtdicke von 30 μm auf ein kupferkaschiertes Laminat aufgetragen und unter Stickstoff während einer Minute mit der im Beispiel 1 beschriebenen 500 W Wolframhalogenlampe aus einer Entfernung von 250 mm belichtet, um einen festen Ueberzug zu liefern. Das beschichtete Laminat wird im Laboratoriumtageslicht, aus welchem der ultraviolette Anteil der Strahlung wegfiltriert wurde, während 1 Woche stehen gelassen, und danach durch ein Negativ während 4 Minuten aus einer Entfernung von 750 mm mit einer 5 000 W Metallhalogenidlampe belichtet. Entwicklung in einem 3 : 1 Gemisch aus γ-Butyrolacton und Butyldigol ergibt ein scharfes Negativbild.

Beispiel 9

Das im Beispiel 5 verwendete Gemisch wird in einer Schichtdicke von 30 μm auf ein kupferkaschiertes Laminat aufgetragen. Die Schicht wird unter Stickstoff während einer Minute mit der im Beispiel 1 beschriebenen Wolframhalogenlampe von 500 W aus einer Entfernung von 200 mm bestrahlt und verfestigt. Die feste Schicht wird im Laboratoriumlicht, aus welchem die UV Strahlung wegfiltriert wurde, während einer Woche gelagert und danach durch ein Negativ während 5 Minuten aus einer Entfernung von 750 mm mit einer 5 000 W Metallhalogenidlampe belichtet. Entwicklung mit einem 3 : 1 Gemisch aus γ-Butyrolacton und Butyldigol ergibt ein Negativbild.

Beispiel 10

Ein Gemisch aus 65 Teilen Harz 1 und 35 Teilen Harz 2 wird zu 0,5 Teilen Bengalrosa, 5 Teilen Tri-n-butyl-4-methylbenzylstannan und 5 Teilen Triphenylsulfoniumhexafluorophosphat beigegeben. Das entstandene Gemisch wird in einer Schichtdicke von 30 μm auf ein kupferkaschiertes Laminat aufgetragen und mit der im Beispiel 1 beschriebenen 500 W Wolframhalogenlampe aus einer Entfernung von 250 mm während 3 Minuten belichtet und verfestigt. Die feste Schicht wird eine Woche im Tageslicht, aus welchem UV Licht ausfiltriert wurde, gelassen und danach durch ein Negativ während 4 Minuten aus einer Entfernung von 750 mm mit einer 5 000 W Metallhalogenidlampe belichtet. Nach Entwicklung mit einem 3 : 1 Gemisch aus γ-Butyrolacton und Butyldigol wird ein Negativbild erhalten.

Beispiel 11

65 Teile Harz 1 und 35 Teile Harz 2 werden mit 5 Teilen Dimethyltricyclo[3,3,1,$1^{3,7}$]-decan-1-carbonylmethylsulfoxoniumhexafluorphosphat, 3 Teilen Benzildimethylketal und 1 Teil Aceton gemischt. Das Gemisch wird in einer Schichtdicke von 30 μm auf ein kupferkaschiertes Laminat aufgetragen und durch Belichtung mit einer 500 W Metallhalogenidlampe, welche mit einem Plastikfilter, das Licht einer Wellenlänge von weniger als 300 nm wegfiltriert, ausgestattet ist, während 30 Sekunden aus einer Entfernung von 750 mm verfestigt. Die feste Schicht wird durch ein Negativ mit der im Beispiel 6 beschriebenen Mitteldruckquecksilberbogenlampe aus einer Entfernung von 200 mm während 2 Minuten belichtet. Entwicklung in einem 3 : 1 Gemisch aus γ-Butyrolacton und Butyldigol ergibt ein klares Negativbild.

Beispiel 12

66 Teile Harz 1, 34 Teile Harz 2, 10 Teile Harz 7, 10 Teile Triphenylsulfoniumhexafluorantimonat, 5 Teile Dimangandecarbonyl und 2 Teile 1,1,1-Trichlorethan werden zu einem homogenen Gemisch vermischt. Das Gemisch wird in einer Schichtdicke von 36 μm auf ein kupferkaschiertes Laminat aufgetragen. Der Ueberzug wird durch Belichtung unter Stickstoff mit der im Beispiel 1 beschriebenen 500 W Antimonhalogenidlampe, ausgestattet mit einem Filter um Strahlung einer Wellenlänge von weniger als 450 nm wegzufiltern, aus einer Entfernung von 200 mm während 15 Minuten verfestigt und dann durch ein Dia mit einer 5 000 W Metallhalogenidlampe aus einer Entfernung von 750 mm während 5 Minuten belichtet. Entwicklung in 1,1,1-Trichlorethan mit Reibung ergibt ein Negativbild des Dias.

Beispiel 13

3 Teile Harz 8, 2 Teile Harz 9, 0,05 Teile Bis(π-methylcyclopentadienyl)bis(σ-4-hexyloxytetrafluorphenyl)titan (IV) und 1 Teil Triphenylsulfoniumhexafluorantimonat werden zu einem homogenen Gemisch vermischt. Das Gemisch wird in einer Schichtdicke von 36 μm auf ein kupferkaschiertes Laminat aufgetragen. Der Ueberzug wird unter Stickstoff mit der im Beispiel 1 beschriebenen 500 W Antimonlampe während 30 Sekunden aus einer Entfernung von 200 mm belichtet und verfestigt. Der feste Ueberzug wird durch ein Dia mit einer 5 000 W Metallhalogenidlampe während 2 Minuten aus einer Entfernung von 750 mm belichtet, danach 5 Minuten auf 90 °C erhitzt und mit einem Gemisch aus 5 Teilen Propylencarbonat, 3 Teilen Butyldigol und 2 Teilen γ-Butylolacton entwickelt, um ein Negativbild des Dias zu geben.

Beispiel 14

Ein Gemisch aus 21,5 Teilen Harz 1, 50 Teilen Harz 11, 25 Teilen Harz 10, 10 Teilen Ethylenglykolbisthioglykolat, 2,5 Teilen Benzildimethylketal und 3,5 Teilen Dimethyltricyclo[3,3,1,$1^{3,7}$]-decan-1-carbonylmethylsulfoxoniumhexafluorphosphat wird in einer Schichtdicke von 30 μm auf ein kupferkaschiertes Laminat aufgetragen. Der Ueberzug wird mit einer 5 000 W Metallhalogenidlampe, welche mit einem Filter, der Licht einer Wellenlänge von weniger als 310 nm wegfiltriert, ausgestattet ist, aus einer Entfernung von 750 mm während 4 Minuten belichtet. Die feste Schicht wird durch ein Dia mit dem im Beispiel 6 beschriebenen Mitteldruckquecksilberbogenlampe aus einer Entfernung von 200 mm während 3 Minuten belichtet. Entwicklung in einem 3 : 1 Gemisch aus γ-Butyrol-acton und Butyldigol ergibt ein Negativbild.

**Patentansprüche**

1. Verfahren zur Bilderzeugung, worin
(i) auf ein Substrat eine Schicht eines flüssigen Stoffgemisches appliziert wird, enthaltend
(A) einen durch freie Radikale polymerisierbaren Rest,
(B) einen strahlungsaktivierbaren Polymerisationsinitiator für (A),
(C) einen strahlungshärtbaren Rest, der verschieden von (A) ist, und gegebenenfalls
(D) einen strahlungsaktivierbaren Katalysator für die Härtung von (C),
(ii) das Stoffgemisch aktinischer Bestrahlung einer Wellenlänge, bei der der Initiator (B) aktiviert wird, aber der Rest (C) und/oder der Katalysator (D) nicht wesentlich aktiviert werden, aussetzt, wodurch (A) polymerisiert und die flüssige Schicht des Stoffgemisches verfestigt wird, aber immer noch härtbar bleibt,
(iii) die verfestigte Schicht in einem vorbestimmten Muster aktinischer Strahlung ausgesetzt wird, welche eine kürzere Wellenlänge als die Bestrahlung der Stufe (ii) hat und bei der der strahlungshärtbare Rest (C) und/oder der Katalysator (D) aktiviert werden, so dass in den bestrahlten Bereichen (C) im wesentlichen gehärtet wird, und
(iv) die Bereiche der verfestigten Schicht, welche nicht im wesentlichen gehärtet sind, entfernt werden.

2. Verfahren nach Anspruch 1, in dem das härtbare flüssige Stoffgemisch

(1) ein Gemisch einer oder mehrerer Verbindungen, die bei einer bestimmten Wellenlänge polymerisiert werden, zusammen mit einer oder mehreren Verbindungen, die durch Bestrahlung bei einer kürzeren Wellenlänge polymerisiert werden, enthalten, oder

(2) eine oder mehrere doppelfunktionelle Verbindungen, welche im gleichen Molekül zwei verschiedene photopolymerisierbare Funktionen enthalten, wobei eine bei einer kürzeren Wellenlänge aktiviert werden kann, als die Wellenlänge, bei der die andere aktiviert wird, oder

(3) eine oder mehrere der beschriebenen doppelfunktionellen Verbindungen zusammen mit einer oder mehreren Verbindungen, welche bei einer längeren oder kürzeren Wellenlänge polymerisiert werden, als die Wellenlänge, bei der das doppelfunktionelle Material polymerisiert werden kann, enthält.

3. Verfahren nach den Ansprüchen 1 oder 2, worin die erste Bestrahlung im sichtbaren Bereich des Spektrums und die zweite Bestrahlung im ultravioletten Bereich durchgeführt wird, oder worin beide Bestrahlungen unter Verwendung ultravioletter Strahlen verschiedener Wellenlänge durchgeführt werden.

4. Verfahren nach einem der vorhergehenden Ansprüche, worin der durch freie Radikal polymerisierbare Rest (A) ein Ester einer ethylenisch ungesättigten Monocarbonsäure, eine Vinylgruppen enthaltende Verbindung oder ein Gemisch eines Polyens mit einem Polythiol ist.

5. Verfahren nach Anspruch 4, worin der Rest (A) ein Ester einer ethylenisch ungesättigten Monocarbonsäure mit mindestens einer Gruppe der Formel

$$CH_2 = C(R^1)COO— \qquad (I),$$

worin $R^1$ Wasserstoff, Chlor oder Brom oder eine Alkylgruppe mit 1 bis 4 Kohlenstoffatomen ist, oder eine vinylsubstituierte aromatische Verbindung, ein Vinylester, eine Allylverbindung oder eine vinylheterocyclische Verbindung ist.

6. Verfahren nach Anspruch 4, worin die Komponente (A) ein Gemisch eines Polyens mit einem Polythiol ist, in dem das Polyen mindestens zwei Gruppen der Formeln

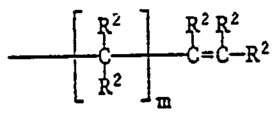

(II)

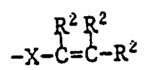

(III)

oder

hat, worin die Gruppen $R^2$, welche gleich oder verschieden sein können, Wasserstoff-, Fluor- und Chloratome, Furyl, Thienyl, Pyridyl, Phenyl, substituiertes Phenyl, Benzyl und substituiertes Benzyl, Alkyl, substituiertes Alkyl, Alkoxy und substituiertes Alkoxy mit 1 bis 9 Kohlenstoffatomen und Cycloalkyl und substituiertes Cycloalkyl mit 3 bis 8 Kohlenstoffatomen sind, wobei die Substituenten unter Chlor- oder Fluoratomen, Acetoxy-, Nitro-, Acetamido-, Phenyl-, Benzyl-, Alkyl-, Alkoxy- und Cycloalkylgruppen gewählt werden, m eine ganze Zahl von 1 bis 9 ist und X eine Gruppe —$NR^2$, —O— oder —S— darstellt, und das Polythiol die allgemeine Formel

$$R^3(SH)_n \qquad (IV)$$

hat, worin $R^3$ eine mehrwertige organische Gruppe darstellt, die keine reaktiven CC Doppelbindungen hat, und n mindestens 2 ist.

7. Verfahren nach irgendeinem der vorhergehenden Ansprüche, worin der Polymerisationsinitiator (B) ein Benzoinether, ein Acyloinether, ein halogeniertes Alkyl- oder Arylderivat, ein aromatisches Carbonylderivat, ein Metallocen, ein Gemisch einer organometallischen Verbindung der Gruppe IVA mit einem photoreduzierbaren Farbstoff, ein Gemisch eines Chinons mit einem aliphatischen Amin, das auf einem aliphatischen α-Kohlenstoffatom einen Wasserstoffatom hat, eine aliphatische Dicarbonylverbindung, die gegebenenfalls mit einem Amin gemischt ist, ein 3-Ketocumarin, ein Acylphosphinoxid, ein Metallcarbonyl oder ein Gemisch eines photoreduzierbaren Farbstoffs mit einem Reduktionsreagenz.

8. Verfahren nach Anspruch 7, worin der Polymerisationsinitiator (B) ein Campherchinon zusammen mit einem tertiären Amin, das ein Wasserstoffatom am aliphatischen α-Kohlenstoffatom hat, Biacetyl, Dimangandecacarbonyl, Benzildimethylketal, Isobutylbenzoinether, 2,2,2-Trichlor-4'-tert.butylacetophenon, Diethoxyacetophenon, ein Cumarin mit einer carbocyclischen oder heterocyclischen aromatischen Ketogruppe in der 3-Stellung, ein Gemisch eines photoreduzierbaren Farbstoffs mit einem Stannan, oder mit einem Elektrondonor, oder ein Titanmetallocen ist.

9. Verfahren nach irgendeinem der vorhergehenden Ansprüche, worin der strahlungshärtbare Rest (C) unter direkter Aktivierung der photoempfindlichen Gruppen polymerisiert wird.

10. Verfahren nach Anspruch 9, worin der strahlungshärtbare Rest (C) ein Stoff mit mindestens zwei Gruppen, die Azido, Cumarin, Stilben, Maleinimido, Pyridinon, Chalcon, Propenon, Pentadienon,

Anthracen oder Acrylestergruppen, die in 3-Stellung mit einer Gruppe substituiert sind, welche eine Doppelbindung oder eine Aromatizität in Konjugation mit der ethylenischen Doppelbindung der Acrylgruppe aufweist, ist.

11. Verfahren nach irgendeinem der Ansprüche 1 bis 8, worin die Bestrahlung einen geeigneten Katalysator (D) aktiviert, welcher dann die polymerisierbaren Gruppen des Restes (C) aktiviert.

12. Verfahren nach Anspruch 11, worin der Rest (C) ein Epoxidharz, ein Phenolharz, ein cyclischer Ether, ein Vinylether, ein cyclischer Ester, ein cyclisches Sulfid, ein cyclisches Amin oder eine cyclische Organosiliciumverbindung ist und (D) ein strahlungsempfindliches aromatisches Diazonium-, Sulfonium-Iodonium-, Sulfoxonium- oder Iodosylsalz ist.

13. Verfahren nach irgendeinem der Ansprüche 2 bis 12, worin das doppelfunktionelle Material im flüssigen Stoffgemisch enthalten ist, und es sich dabei um eine Epoxidgruppe enthaltenden Ester einer ethylenisch ungesättigten Monocarbonsäure, eine Verbindung, die sowohl eine ethylenisch ungesättigte Carboxylestergruppe als auch eine Anthrylgruppe enthält, oder eine Verbindung, die eine Epoxidgruppe und eine Allyl- oder Methallylgruppe enthält, handelt.

14. Stoffgemisch geeignet zur Verwendung im Verfahren nach den Ansprüchen 1 bis 13, enthaltend die Komponenten (A), (B), (C) und gegebenenfalls (D) gemäss Anspruch 1, wobei (B) ein Metallocen oder ein Gemisch einer organometallischen Verbindung der Gruppe IVA mit einem photoreduzierbaren Farbstoff ist.

15. Stoffgemisch nach Anspruch 14, worin der strahlungsaktivierbare Polymerisationsinitiator (B) ein Titanocen der Formel

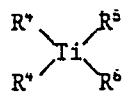

(V)

ist, worin jede der Gruppen $R^4$ unabhängig voneinander eine gegebenenfalls substituierte Cyclopentadienyl- oder Indenylgruppe ist, oder die zwei $R^4$ Gruppen zusammen Alkylidengruppen mit 2 bis 12 Kohlenstoffatomen, eine Cycloalkylidengruppe mit 5 bis 7 Kohlenstoffatomen im Ring, eine Gruppe $Si(R^7)_2$ oder $Sn(R^7)_2$ oder eine gegebenenfalls substituierte Gruppe der Formel

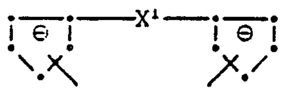

darstellen, worin $X^1$ Methylen, Ethylen oder 1,3-Propylen bedeutet, $R^5$ einen 6-gliedrigen carbocyclischen oder 5- oder 6-gliedrigen heterocyclischen aromatischen Ring bedeutet, der in mindestens einer der ortho-Stellungen zur Metall-Kohlenstoffbindung durch ein Fluoratom substituiert ist, wobei der Ring gegebenenfalls weitere Substituenten aufweisen kann, oder $R^5$ mit $R^6$ zusammen eine Gruppe -Q-Y-Q- bedeuten, und Q für einen 5- oder 6-gliedrigen carbocyclischen oder heterocyclischen aromatischen Ring steht, in welchem jede der Bindungen ortho zur Q-Y Bindung ist und jede Stellung meta zur Q-Y Bindung durch Fluor substituiert ist, wobei die Gruppen Q gegebenenfalls weitere Substituenten haben können, Y eine Methylengruppe, eine Alkylidengruppe mit 2 bis 12 Kohlenstoffatomen, eine Cycloalkylidengruppe mit 5 bis 7 Kohlenstoffatomen im Ring, eine direkte Bindung, eine Gruppe $NR^7$, einen Sauerstoff- oder Schwefelatom, eine Gruppe $—SO_2—$, $—CO—$, $—Si(R^7)_2—$ oder $—Sn(R^7)_2—$bedeutet, $R^6$ eine Alkinyl- oder Phenylalkinylgruppe, die substituiert sein können, eine Azido oder Cyanogruppe oder eine Gruppe der Formel $Si(R^7)_2$ oder $Sn(R^7)_2$ ist oder die gleiche Bedeutung wie die Gruppe $R^5$ hat, und $R^7$ eine Alkylgruppe mit 1 bis 12 Kohlenstoffatomen, eine Cycloalkylgruppe mit 5 bis 12 Kohlenstoffatomen, eine Arylgruppe mit 6 bis 16 Kohlenstoffatomen oder eine Aralkylgruppe mit 7 bis 16 Kohlenstoffatomen ist.

16. Stoffgemisch nach Anspruch 14, worin der strahlungsaktivierbare Polymerisationsinitiator (B) ein Organostannan der Formel

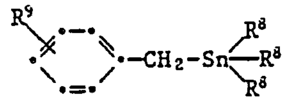

(VI)

ist, worin $R^8$ eine Alkylgruppe mit 1 bis 4 Kohlenstoffatomen oder eine Alkenyl- oder Alkynylgruppe mit 2 bis 4 Kohlenstoffatomen und $R^9$ ein Wasserstoff- oder Halogenatom oder eine Alkyl- oder Alkoxygruppe mit 1 bis 4 Kohlenstoffatomen sind, zusammen mit einem photoreduzierbaren Farbstoff.

## Claims

1. A process for the production of an image which comprises

(i) applying to a substrate a layer of a liquid composition containing

(A) a radical that is polymerisable by means of free radicals,

(B) a radiation-activated polymerisation initiator for (A)

(C) a radiation-curable radical that is different from (A) and optionally

(D) a radiation-activated catalyst for the cure of (C),

(ii) subjecting the composition to actinic radiation having a wavelength at which the initiator (B) is activated but at which the radical (C) and/or the catalyst (D) are not substantially activated, thereby polymerising (A) such that the liquid layer of the composition is solidified, but remains curable,

(iii) subjecting the solidified layer in a predetermined pattern to actinic radiation having a wavelength that is shorter than that of the radiation used in stage (ii) and at which the radiation-curable radical (C) and/or the catalyst (D) is activated, such that in the irradiated areas (C) is substantially cured, and

(iv) removing areas of the solidified layer that have not been substantially cured.

2. A process according to claim 1 wherein the curable liquid composition contains

(1) a mixture of one or more compounds that are polymerised at a certain wavelength, together with one or more compounds that are polymerised by irradiation at a shorter wavelength, or

(2) one or more dual-functional compounds having in the same molecule two different photopolymerisable functions, one of which can be activated at a shorter wavelength than the wavelength at which the other is activated, or

(3) one or more of said dual-functional compounds together with one or more compounds that are polymerised at a longer or shorter wavelength than the wavelength at which the dual-functional material can be polymerised.

3. A process according to claim 1 or 2, wherein the first irradiation is effected in the visible region of the spectrum, and the second irradiation is effected in the ultraviolet region or wherein both irradiations are effected using ultraviolet radiation, of different wavelengths.

4. A process according to any one of the previous claims wherein the radical (A) polymerisable by means of free radicals is an ester of an ethylenically unsaturated monocarboxylic acid, a vinyl group-containing compound, or a mixture of a polyene with a polythiol.

5. A process according to claim 4 wherein the radical (A) is an ester of an ethylenically unsaturated monocarboxylic acid having at least one group of the formula

$$CH_2 = C(R^1)COO— \qquad (I)$$

where $R_1$ is hydrogen, chlorine, or bromine or an alkyl group of 1 to 4 carbon atoms, or a vinyl-substituted aromatic compound, a vinyl ester, an allyl compound or a vinyl heterocyclic compound.

6. A process according to claim 4 wherein the component (A) is a mixture of a polyene with a polythiol in which the polyene has at least two groups of the formula

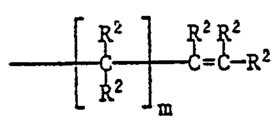
(II)

or

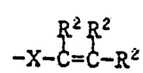
(III)

where the groups $R_2$, which may be the same or different, are hydrogen, fluorine and chlorine atoms, furyl, thienyl, pyridyl, phenyl, substituted phenyl, benzyl and substituted benzyl, alkyl, substituted alkyl, alkoxy and substituted alkoxy of from 1 to 9 carbon atoms and cycloalkyl and substituted cycloalkyl of from 3 to 8 carbon atoms, the substituents being selected from chlorine or fluorine atoms and acetoxy, nitro, acetamido, phenyl, benzyl, alkyl, alkoxy and cycloalkyl groups, m is an integer of from 1 to 9, and X is a group $—NR^2$, —O—, or —S—, and the polythiol has the general formula

$$R^3(SH)_n \qquad (IV)$$

where $R^3$ is a polyvalent organic group which does not have any reactive CC double bonds and n is at least 2.

7. A process according to any one of the previous claims wherein the polymerisation initiator (B) is a benzoin ether, an acyloin ether, a halogenated alkyl or aryl derivative, an aromatic carbonyl derivative, a metallocene, a mixture of a group IVA organometallic compound with a photoreducible dye, a mixture of a quinone with an aliphatic amine having a hydrogen atom attached to an aliphatic a-carbon atom, an aliphatic dicarbonyl compound optionally mixed with an amine, a 3-ketocoumarin, an acyl phosphine oxide, a metal carbonyl or a mixture of a photoreducible dye with a reducing agent.

8. A process according to claim 7 wherein the polymerisation initiator (B) is camphorquinone

together with a tertiary amine having a hydrogen atom attached to an aliphatic α-carbon atom, biacetyl, dimanganese decacarbonyl, benzil dimethyl ketal, isobutyl benzoin ether, 2,2,2-trichloro-4'-tert-butylacetophenone, diethoxyacetophenone, a coumarin having a carbocyclic or heterocyclic aromatic ketone group in the 3-position, a mixture of a photoreducible dye with a stannane, a mixture of a photoreducible dye with an electron donor, or a titanium metallocene.

9. A process according to any one of the previous claims wherein the radiation-curable radical (C) is polymerised by direct activation of the photosensitive groups.

10. A process according to claim 9 wherein the radiation-curable radical (C) is a material having at least two groups which are azido, coumarin, stilbene, maleimido, pyridinone, chalcone, propenone, pentadienone, anthracene, or acrylic ester groups which are substituted in the 3-position by a group having a double bond or aromaticity in conjugation with the ethylenic double bond of the acrylic group.

11. A process according to any one of claims 1 to 8 wherein the irradiation activates a suitable catalyst (D) which then activates the polymerisable groups of the radical (C).

12. A process according to claim 11 wherein the radical (C) is an epoxy resin, a phenolic resin, a cyclic ether, a vinyl ether, a cyclic ester, a cyclic sulphide, a cyclic amine or an organosilicon cyclic compound and (D) is a radiation-sensitive aromatic diazonium, sulphonium, iodonium, sulphoxonium or iodosyl salt.

13. A process according to any one of claims 2 to 12 wherein the dual-functional material is contained in the liquid composition and is an ester of an ethylenically unsaturated monocarboxylic acid containing an epoxide group, a compound containing both an ethylenically unsaturated carboxylic ester group and an anthryl group or a compound containing an epoxide group and allyl or methallyl group.

14. A composition suitable for use in the process according to any one of claims 1 to 13, containing the components (A), (B), (C) and optionally (D) according to claim 1, where (B) is a metallocene or a mixture of a Group IVA organometallic compound with a photoreducible dye.

15. A composition according to claim 14 wherein the radiation-activated polymerisation initiator (B) is a titanocene of the formula

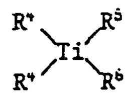

(V)

where each group $R^4$ is independently of the other an optionally substituted cyclopentadienyl or indenyl group or together the two $R^4$ groups form alkylidene groups of 2 to 12 carbon atoms, a cycloalkylidene group having from 5 to 7 carbon atoms in the ring, a group $Si(R^7)_2$ or $Sn(R^7)_2$, or an optionally substituted group of the formula

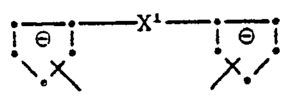

where $X^1$ is methylene, ethylene, or 1,3-propylene, $R^5$ is a 6-membered carbocyclic or 5- or 6-membered heterocyclic aromatic ring, substituted by a fluorine atom in at least one of the positions ortho to the metal-carbon bond, the ring optionally being further substituted, or $R^5$ with $R^6$ together are a group -Q-Y-Q-, and Q is a 5- or 6-membered carbocyclic or heterocyclic aromatic ring, in which each of the bonds is ortho to the Q-Y bond, and each position meta to the Q-Y bond is substituted by fluorine, the groups Q optionally being further substituted, Y denotes a methylene group, an alkylidene group having from 2 to 12 carbon atoms, a cycloalkylidene group having from 5 to 7 carbon atoms in the ring, a direct bond, a group $NR^7$, an oxygen or sulphur atom, or a group $-SO_2-$, $-CO-$, $-Si(R^7)_2-$, or $-Sn(R^7)_2-$, $R^6$ is an alkynyl or phenylalkynyl group that may be substituted, an azido or cyano group, or a group of the formula $Si(R^7)_2$ or $Sn(R^7)_2$, or it has the same meaning as the group $R^5$, and $R^7$ is an alkyl group of from 1 to 12 carbon atoms, a cycloalkyl group of from 5 to 12 carbon atoms, an aryl group of from 6 to 16 carbon atoms, or an aralkyl group of from 7 to 16 carbon atoms.

16. A composition according to claim 14 where the radiation-activated polymerisation initiator (B) is an organostannane of the formula

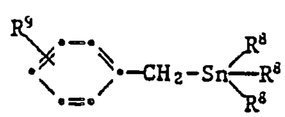

(VI)

where $R^8$ is an alkyl group of from 1 to 4 carbon atoms, or an alkenyl or alkynyl group of from 2 to 4 carbon atoms, and $R^9$ is a hydrogen or halogen atom or an alkyl or alkoxy group of from 1 to 4 carbon atoms, together with a photoreducible dye.

**Revendications**

1. Procédé pour créer des images, procédé selon lequel :

(i) on applique sur un substrat une couche d'un mélange liquide contenant :

(A) un radical polymérisable par des radicaux libres,

(B) un amorceur de polymérisation photo-activable pour (A),

(C) un radical photodurcissable qui est différent de (A), et éventuellement

(D) un catalyseur photo-activable pour le durcissement de (C),

(ii) on expose le mélange à un rayonnement actinique d'une longueur d'onde à laquelle l'amorceur (B) est activé mais le radical (C) et/ou le catalyseur (D) ne sont pas sensiblement activés, exposition au cours de laquelle (A) est polymérisé et la couche liquide du mélange est solidifiée mais tout en restant encore durcissable,

(iii) on expose la couche solidifiée, selon un modèle donné, à un rayonnement actinique qui a une longueur d'onde plus courte que celle du rayonnement de l'étape (ii) et sous l'effet duquel le radical photodurcissable (C) et/ou le catalyseur (D) sont activés, de telle sorte que (C) soit essentiellement durci aux endroits touchés par le rayonnement, et

(iv) on élimine les endroits de la couche solidifiée qui ne sont pas essentiellement durcis.

2. Procédé selon la revendication 1, dans lequel le mélange liquide durcissable contient :

(1) un mélange d'un ou plusieurs composés qui se polymérisent à une longueur d'onde déterminée, avec un ou plusieurs composés qui se polymérisent sous l'effet d'un rayonnement d'une longueur d'onde plus courte, ou

(2) un ou plusieurs composés bifonctionnels renfermant, dans la même molécule, deux fonctions photopolymérisables différentes, dont l'une peut être activée à une longueur d'onde plus courte que celle à laquelle l'autre est activée, ou

(3) un ou plusieurs des composés bifonctionnels décrits ci-dessus, avec un ou plusieurs composés qui se polymérisent à une longueur d'onde plus grande ou plus petite que la longueur d'onde à laquelle la matière bifonctionnelle peut être polymérisée.

3. Procédé selon l'une des revendications 1 et 2 selon lequel la première irradiation est effectuée dans la région visible du spectre et la seconde dans la région ultraviolette, ou selon lequel les deux irradiations sont effectuées avec des rayons ultraviolets de longueurs d'ondes différentes.

4. Procédé selon l'une quelconque des revendications précédentes selon lequel le radical (A) polymérisable par des radicaux libres est un ester d'un acide monocarboxylique éthylénique, un composé contenant des radicaux vinyles, ou un mélange d'un polyène et d'un polythiol.

5. Procédé selon la revendication 4 selon lequel le radical (A) est un ester d'un acide monocarboxylique éthylénique renfermant au moins un radical répondant à la formule I

$$CH_2 = C(R^1)COO— \quad (I)$$

dans laquelle $R^1$ représente l'hydrogène, le chlore ou le brome ou un radical alkyle contenant de 1 à 4 atomes de carbone, ou un composé aromatique porteur d'un radical vinyle, un ester vinylique, un composé allylique ou un composé hétérocyclique porteur d'un radical vinyle.

6. Procédé selon la revendication 4 selon lequel la composante (A) est un mélange d'un polyène et d'un polythiol dont le polyène contient au moins deux radicaux répondant à l'une des formules :

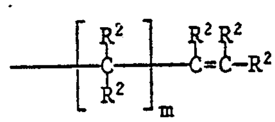

(II)

et

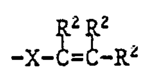

(III)

dans lesquelles les $R^2$ représentent chacun, indépendamment les uns des autres, un atome d'hydrogène, de fluor ou de chlore, un radical furyle, thiényle, pyridyle ou phényle, un phényle substitué, un benzyle, un benzyle substitué, un radical alkyle, alkyle substitué, alcoxy ou alcoxy substitué contenant de 1 à 9 atomes de carbone, ou un radical cycloalkyle ou cycloalkyle substitué contenant de 3 à 8 atomes de carbone, les substituants pouvant être des atomes de chlore ou de fluor ou des radicaux acétoxy, nitro, acétylamino, phényles, benzyles, alkyles, alcoxy ou cycloalkyles, m désigne un nombre entier 1 à 9, et X représente un radical $—NR^2—$, $—O—$ ou $—S—$, et le polythiol répond à la formule générale :

$$R^3(SH)_n \quad (IV)$$

dans laquelle $R^3$ représente un radical organique multivalent qui ne contient pas de doubles liaisons carbone-carbone réactives, et n est au moins égal à 2.

7. Procédé selon l'une quelconque des revendications précédentes, selon lequel l'amorceur de polymérisation (B) est un éther de la benzoïne, un éther d'acyloïne, un composé alkylique ou arylique halogéné, un composé carbonyle aromatique, un métallocène, un mélange d'un composé organométallique d'un métal du groupe IVA et d'un colorant photoréductible, un mélange d'une quinone et d'une amine aliphatique portant un atome d'hydrogène sur un atome de carbone α aliphatique, un composé dicarbonylique aliphatique, éventuellement en mélange avec une amine, une céto-3 coumarine, un oxyde d'acylphosphine, un métal-carbonyle, ou un mélange d'un colorant photoréductible et d'un agent réducteur.

8. Procédé selon la revendication 7 selon lequel l'amorceur de polymérisation (B) est une camphoquinone associée à une amine tertiaire contenant un atome d'hydrogène sur l'atome de carbone α-aliphatique, le diacétyle, le dimanganèse-décacarbonyle, le benzile-diméthylacétal, l'éther isobutylique de la benzoïne, la trichloro-2,2,2 tert-butyl-4' acétophénone, la diéthoxy-acétophénone, une coumarine contenant, à la position 3, un radical céto aromatique carbocyclique ou hétérocyclique, un mélange d'un colorant photoréductible et d'un stannane, ou d'un donneur d'électrons, ou un métallocène dérivant du titane.

9. Procédé selon l'une quelconque des revendications précédentes selon lequel le radical photodurcissable (C) est polymérisé avec activation directe des radicaux photosensibles.

10. Procédé selon la revendication 9, selon lequel le radical photodurcissable (C) est un corps contenant au moins deux radicaux pris dans l'ensemble constitué par les radicaux d'azoture, de coumarine, de stilbène, de maléimide, de pyridinone, de chalcone, de propénone, de pentadiénone et d'anthracène et les radicaux d'esters acryliques qui portent, en position 3, un radical comportant une double liaison ou une aromaticité en conjugaison avec la double liaison éthylénique du radical acryle.

11. Procédé selon l'une quelconque des revendications 1 à 8 selon lequel l'irradiation active un catalyseur (D) approprié, lequel active ensuite les radicaux polymérisables du radical (C).

12. Procédé selon la revendication 11 selon lequel le radical (C) est une résine époxydique, une résine phénolique, un éther cyclique, un éther vinylique, un ester cyclique, un sulfure cyclique, une amine cyclique ou un composé organosilicique cyclique, et (D) est un sel de diazonium, de sulfonium, d'iodonium, de sulfoxonium ou d'iodosyle aromatique photosensible.

13. Procédé selon l'une quelconque des revendications 2 à 12 selon lequel il y a une matière bifonctionnelle dans le mélange liquide et celle-ci est un ester d'acide monocarboxylique éthylénique contenant un radical époxy, un composé contenant à la fois un radical d'ester carboxylique éthylénique et un radical anthryle, ou un composé contenant un radical époxy et un radical allyle ou méthallyle.

14. Mélange utilisable dans le procédé selon l'une quelconque des revendications 1 à 13, mélange qui contient les composantes (A), (B), (C) et, éventuellement, (D) selon la revendication 1, la composante (B) étant un métallocène ou un mélange d'un composé organométallique dérivant d'un métal du groupe IVA et d'un colorant photoréductible.

15. Mélange selon la revendication 14 dans lequel l'amorceur de polymérisation photo-activable (B) est un titanocène répondant à la formule (V)

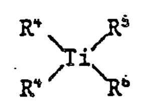

(V)

dans laquelle les symboles $R^4$ représentent chacun, indépendamment l'un de l'autre, un radical cyclopentadiényle ou indényle éventuellement substitué, ou les deux symboles $R^4$ représentent ensemble un radical alkylidène contenant de 2 à 12 atomes de carbone, un radical cycloalkylidène contenant de 5 à 7 atomes de carbone dans le cycle, un radical $Si(R^7)_2$ ou $Sn(R^7)_2$, ou un radical, éventuellement substitué, qui répond à la formule suivante :

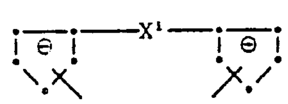

(dans laquelle $X^1$ représente un radical méthylène, éthylène ou propylène-1,3), $R^5$ représente un radical aromatique carbocyclique à 6 maillons ou hétérocyclique à 5 ou 6 maillons qui porte un atome de fluor en au moins une des positions ortho par rapport à la liaison métal-carbone et qui peut éventuellement porter d'autres substituants, ou $R^5$ et $R^6$ forment ensemble un radical -Q-Y-Q- dans lequel Q représente un radical aromatique carbocylique ou hétérocyclique à 5 ou 6 maillons dont chacune des deux liaisons est en position ortho par rapport à la liaison Q-Y et dont chacune des positions méta par rapport à la liaison Q-Y porte un atome de fluor, les radicaux Q pouvant éventuellement porter d'autres substituants, et Y représente un radical méthylène, un radical alkylidène contenant de 2 à 12 atomes de carbone, un radical cycloalkylidène contenant de 5 à 7 atomes de carbone dans le cycle, une liaison directe, un radical $NR^7$, un atome d'oxygène ou de soufre, ou un radical $—SO^2—$, $—CO—$, $—Si(R^7)_2—$ ou $—Sn(R^7)_2—$, $R^6$ représente un radical alcynyle ou phénylalcynyle, éventuellement substitué, un radical azido ou cyano ou un radical de formule $Si(R^7)_2$ ou $Sn(R^7)_2$ ou à l'une des significations qui ont été données pour $R^5$, et $R^7$

représente un radical alkyle contenant de 1 à 12 atomes de carbone, un radical cycloalkyle contenant de 5 à 12 atomes de carbone, un radical aryle contenant de 6 à 16 atomes de carbone ou un radical aralkyle contenant de 7 à 16 atomes de carbone.

16. Mélange selon la revendication 14 dans lequel l'amorceur de photopolymérisation photoactivable (B) est un organostannane répondant à la formule :

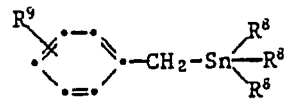

(VI)

dans laquelle $R^8$ représente un radical alkyle contenant de 1 à 4 atomes de carbone ou un radical alcényle ou alcynyle contenant de 2 à 4 atomes de carbone, et $R^9$ représente un atome d'hydrogène ou d'halogène ou un radical alkyle ou alcoxy contenant de 1 à 4 atomes de carbone, associé à un colorant photoréductible.